# FASCICULE DE BREVET EUROPEEN

(11) **EP 2 461 351 B1**
(45) Date de publication et mention de la délivrance du brevet: **18.02.2015**
(21) Numéro de dépôt: 11191057.6
(22) Date de dépôt: 29.11.2011
(51) Int. Cl.: H01L 21/28, H01L 29/792, H01L 29/423, H01L 27/115, G11C 16/00

(54) **Cellule mémoire électronique à double grille et son procédé de fabrication**
Elektronische Speicherzelle mit Doppel-Gate und Verfahren zu ihrer Herstellung
Double-gate electronic memory cell and method of fabricating thereof

(30) Priorité: 02.12.2010 FR 1060023
(43) Date de publication de la demande: 06.06.2012
(73) Titulaire: Commissariat à l'Énergie Atomique et aux Énergies Alternatives, 75015 Paris (FR)
(72) Inventeur: Gely, Marc, 38240 MEYLAN (FR); Molas, Gabriel, 38000 GRENOBLE (FR)
(74) Mandataire: Ilgart, Jean-Christophe

(56) Documents cités:
- US-A1- 2008 144 394
- US-A1- 2009 224 306
- US-A1- 2010 200 909

## Description

### DOMAINE TECHNIQUE

L'invention concerne le domaine des dispositifs mémoires, ou mémoires, électroniques non-volatiles, et plus particulièrement celui des mémoires électroniques de type Flash à double grille (grille flottante de mémorisation et grille de commande).

### ÉTAT DE LA TECHNIQUE ANTÉRIEURE

Il existe plusieurs types de mémoires non-volatiles, c'est-à-dire des mémoires conservant une information mémorisée en l'absence d'alimentation électrique, pouvant être écrites et/ou effacées électriquement :
- les EPROMs (« Erasable Programmable Read Only Memories » en anglais, ou mémoires mortes effaçables et programmables), dont le contenu peut être écrit électriquement, mais qui doivent être soumises à un rayonnement UV pour effacer les informations mémorisées,
- les EEPROMs (« Electrically Erasable Programmable ROMs » en anglais, ou mémoires mortes effaçables et programmables électriquement), dont le contenu peut être écrit et effacé électriquement, mais qui requièrent, pour leur réalisation, des surfaces de semi-conducteur plus importantes que les mémoires de type EPROM, et qui sont donc plus coûteuses à réaliser.

Il existe également des mémoires non volatiles, appelées mémoires Flash, qui ne présentent pas les inconvénients des mémoires EPROMs ou EEPROMs mentionnés ci-dessus. En effet, une mémoire Flash est formée d'une pluralité de cellules mémoires pouvant être programmées électriquement de manière individuelle, un grand nombre de cellules, appelé bloc, secteur ou page, pouvant être effacées simultanément et électriquement. Les mémoires Flash combinent à la fois l'avantage des mémoires EPROMs en termes de densité d'intégration et l'avantage des mémoires EEPROMs en termes d'effacement électrique.

De plus, la durabilité et la faible consommation électrique des mémoires Flash les rendent intéressantes pour de nombreuses applications : appareils photos numériques, téléphones cellulaires, imprimantes, assistants personnels, ordinateurs portables, ou encore dispositifs portables de lecture et d'enregistrement sonore, clés USB, etc. De plus, les mémoires Flash ne possèdent pas d'éléments mécaniques, ce qui leurs confère une assez grande résistance aux chocs.

La plupart des mémoires Flash sont du type « stand-alone » et présentent de grandes capacités de stockage, généralement supérieures à 1 Gb, et sont dédiées aux applications de stockage de masse.

Cependant, il existe également des mémoires Flash dites embarquées (« embedded memories ») dont la réalisation est intégrée dans un procédé de type CMOS et qui trouvent un intérêt croissant, par exemple dans les domaines de l'automobile ou des microcontrôleurs, pour le stockage de données ou de codes. Ces mémoires Flash embarquées sont réalisées sur une puce qui comporte également des dispositifs CMOS destinés à réaliser des fonctions logiques autres qu'une mémorisation de données. Ces mémoires Flash embarquées sont généralement réalisées pour des capacités de stockage plus faibles que celles des mémoires de type « stand-alone », leurs capacités pouvant varier généralement de quelques bits à quelques Mb. Les caractéristiques visées des mémoires Flash embarquées sont un faible coût de réalisation, une excellente fiabilité (notamment à haute température), une faible consommation électrique, ou encore une vitesse de programmation élevée, ces caractéristiques étant fonction de l'application à laquelle elles sont destinées.

La plupart des mémoires Flash comportent une structure de type transistor MOS (grille, source, drain et canal) comportant un site de stockage de charges électriques, appelé grille flottante, formé par exemple d'une couche de polysilicium disposée entre deux couches d'oxyde, et disposé entre le matériau électriquement conducteur de grille et le canal du transistor. Une mémorisation est réalisée en appliquant sur le matériau conducteur une tension supérieure à la tension de seuil, par exemple comprise entre 15 V et 20 V, qui code l'information à stocker et qui dépend de la charge piégée dans la grille flottante.

Cependant, de telles mémoires présentent des inconvénients limitant la réduction de leurs dimensions. En effet, une réduction de l'épaisseur de l'oxyde tunnel (oxyde disposé entre le canal et la couche de polysilicium) entraîne une augmentation du SILC (« Stress Induced Leakage Current »). Or, l'utilisation prolongée d'une telle mémoire (répétition de cycles écriture - effacement) génère des défauts dans l'oxyde tunnel qui vont assister la conduction de charges et dégrader la rétention des charges dans la grille flottante, ce qui pose des problèmes dans le cas d'un SILC important. Dans la pratique, il est donc difficile de réduire l'épaisseur de l'oxyde tunnel de ces mémoires à moins de 8 nm sans que le SILC ne devienne un phénomène critique pour la mémorisation. De plus, en réduisant les dimensions d'une telle cellule mémoire, le couplage parasite entre les grilles flottantes de deux cellules adjacentes d'une même mémoire devient important et peut donc dégrader la fiabilité de la mémoire.

Pour ces raisons, des mémoires de type MONOS (Métal Oxyde Nitrure Oxyde Silicium), également appelées mémoires NROM, ont été proposées pour remplacer les mémoires à grille flottante en polysilicium. Le document US 5 768 192 décrit de telles mémoires dans lesquelles les charges électriques sont stockées dans des pièges formés dans une grille flottante composée de nitrure et disposée entre deux couches d'oxyde. Dans une telle couche de nitrure, les pièges sont isolés les uns des autres. Ainsi, un électron stocké dans un des pièges reste localisé physiquement dans ce piège, ce qui rend ces mémoires beaucoup plus « résistantes » aux défauts dans l'oxyde tunnel, et donc moins impactées par une augmentation du SILC. En effet, en présence d'un défaut dans l'oxyde tunnel, la couche de mémorisation, c'est-à-dire la couche de nitrure, perd uniquement les électrons situés dans l'entourage proche du défaut, les autres électrons piégés n'étant pas affectés par ce défaut. Ces mémoires disposent donc d'une meilleure fiabilité. Il est ainsi possible d'avoir un oxyde tunnel d'épaisseur inférieure à environ 8 nm, et donc de réduire les tensions de programmation nécessaires. De plus, du fait de la faible épaisseur du nitrure pour former la couche de mémorisation, le couplage entre deux cellules mémoires adjacentes est fortement réduit par rapport à des cellules à grille flottante en polysilicium. Enfin, la structure d'une mémoire de type NROM est également adaptée pour réaliser des mémoires embarquées en raison de la simplicité du procédé d'intégration de ces mémoires.

Le document de S. Kianian et al., "A novel 3 volts-only, small sector erase, high density flash E2PROM", Technical Digest of VLSI Technology, 1994, p.71, décrit un autre type de mémoire, appelée mémoire « split-gate », qui comporte au sein d'une même cellule mémoire un transistor de mémorisation et un transistor de sélection (ou transistor de commande) formés sur une unique zone active. Une telle cellule mémoire à double grille est généralement programmée par injection de porteurs par la source (« source side injection » en anglais), mécanisme qui requiert justement la présence d'un transistor de sélection accolé au transistor de mémorisation, et qui permet d'augmenter la vitesse de programmation tout en réduisant la consommation par rapport à une mémoire de type NROM.

Afin de bénéficier des avantages de chaque structure, split-gate et NROM, le document US 2004/207025 A1 propose un autre type de mémoire à double grille combinant la structure d'une mémoire de type NROM avec une architecture split-gate. Une des difficultés pour réaliser ces mémoires concerne le contrôle de la position des grilles (grille de commande et grille de mémorisation) l'une par rapport à l'autre.

En effet, ces grilles sont réalisées par deux photolithographies successives, le désalignement de la seconde grille par rapport à la première grille fixant la longueur de la seconde grille. Un mauvais contrôle des positions relatives des deux grilles se traduit donc par un mauvais contrôle des caractéristiques électriques du second transistor, et donc de mauvaises performances de la mémoire. Par conséquent, un contrôle très précis de la position des grilles est nécessaire lors de la réalisation de ce type de mémoire.

Afin de s'affranchir de cette contrainte d'alignement, le document US 7 130 223 B2 propose de réaliser une mémoire à double grille combinant la structure d'une mémoire de type NROM avec une architecture split-gate et dans laquelle la grille de mémorisation, c'est-à-dire la grille comportant la couche de mémorisation de données, est réalisée sous la forme d'un espaceur latéral de la grille de commande, disposé contre un des deux flancs latéraux de la grille de commande. Une telle structure permet de contrôler précisément la position et la dimension de la grille de mémorisation par rapport à la grille de commande car, du fait que la grille de mémorisation soit réalisée sous la forme d'un espaceur latéral, celle-ci est donc auto-alignée par rapport à la grille de commande.

Toutefois, avec une telle structure, il est très difficile de réaliser ensuite une reprise de contact électrique sur la grille de mémorisation compte tenu des faibles dimensions de cette grille en forme d'espaceur latéral. De plus, du fait de la proximité de la grille de mémorisation avec la grille de commande, il existe un risque très important que le contact électrique réalisé sur la grille en espaceur créé un court-circuit entre ces deux grilles en cas de désalignement lors de la réalisation du contact électrique.

US 2010/0200909 décrit une cellule mémoire non-volatile.

### EXPOSÉ DE L'INVENTION

Un but de la présente invention est de proposer une nouvelle cellule mémoire électronique à double grille permettant de réaliser une reprise de contact électrique de chacune de grille sans risque de court-circuit entre les grilles, ne nécessitant pas un alignement très précis des contacts électriques par rapport aux grilles de la cellule mémoire, et cela sans avoir à mettre en oeuvre un niveau de photolithographie supplémentaire dédié à cette reprise de contact électrique.

Pour cela, la présente invention propose une cellule mémoire électronique comprenant au moins :
- une zone active formée dans une couche de semi-conducteur et comportant un canal disposé entre une source et un drain,
- une première grille disposée au moins sur une première partie du canal,
- au moins une portion d'un premier espaceur latéral disposé contre au moins un flanc latéral de la première grille, dont une partie forme une seconde grille disposée sur au moins une seconde partie du canal,
   l'une de la première ou de la seconde grille comportant en outre un empilement de couches dont au moins une desdites couches est apte à stocker des charges électriques,
   la cellule mémoire comportant en outre au moins une portion d'un deuxième espaceur latéral disposé contre au moins un flanc latéral d'un bloc disposé sur la couche de semi-conducteur, le deuxième espaceur latéral étant en contact avec le premier espaceur latéral, le premier et le second espaceur latéral étant composés de matériaux similaires, ladite portion du second espaceur latéral formant au moins une partie d'un plot de contact électrique relié électriquement à la seconde grille.

Une telle cellule mémoire électronique propose donc de réaliser un plot de contact électrique relié électriquement à la seconde grille à partir de deux espaceurs latéraux réalisés avec les mêmes matériaux que ceux formant la seconde grille, sauf le diélectrique de grille qui n'est présent qu'au niveau du canal. Ainsi, on garantit la continuité électrique entre la seconde grille et le plot de contact électrique. De plus, compte tenu du fait que le plot de contact est formé par deux espaceurs latéraux en contact l'un avec l'autre, la surface pour réaliser la reprise de contact électrique est supérieure à la surface de la seconde grille seule formée par le premier espaceur latéral.

Le bloc contre lequel est disposée le deuxième espaceur latéral est distinct de la première grille. Ce bloc est également distinct de la deuxième grille. De plus, le bloc est espacé de la première grille, c'est-à-dire ne forme pas une portion continue de matériau(x) avec la première grille. Le bloc ne correspond pas non plus à une partie du premier espaceur latéral ou du deuxième espaceur latéral, c'est-à-dire est distinct du premier espaceur latéral et du deuxième espaceur latéral.

Le plot de contact électrique peut correspondre donc à deux portions d'espaceurs latéraux différents disposées en regard l'une de l'autre, et par exemple en contact l'une avec l'autre.

Etant donné que le plot de contact électrique réalisé sous la forme de deux espaceurs latéraux est formé des mêmes matériaux que ceux formant la seconde grille, ce plot de contact électrique peut donc être réalisé sans nécessiter la mise en oeuvre d'une étape de photolithographie dédiée à sa réalisation.

La portion du premier espaceur latéral peut être rectiligne. Ainsi, la seconde grille peut être disposée le long d'un unique flanc latéral de la première grille.

Dans une autre variante, la portion du premier espaceur latéral peut être disposée contre deux flancs latéraux de la première grille distincts et perpendiculaires l'un par rapport à l'autre. Dans ce cas, le plot de contact électrique peut être en partie formé par une portion du premier espaceur latéral disposée contre l'un des deux flancs latéraux qui est sensiblement perpendiculaire à une direction source-drain.

Le bloc peut être formé par des matériaux similaires à ceux formant une partie de la première grille. Ainsi, le bloc et la première grille peuvent être réalisés au cours d'étapes technologiques communes.

La couche apte à stocker des charges électriques dudit empilement de couches peut être disposée entre deux couches de matériau diélectrique dudit empilement. Un tel empilement peut par exemple être de type ONO (Oxyde-Nitrure-Oxyde).

Lorsque la seconde grille comporte ledit empilement de couches, le second espaceur latéral peut être formé d'une partie des couches dudit empilement.

Le plot de contact électrique peut être en partie formé par la portion du premier espaceur.

La cellule mémoire électronique peut comporter en outre au moins une portion d'un troisième espaceur latéral disposé contre au moins un flanc latéral d'un second bloc et en contact avec le deuxième espaceur latéral, et dans laquelle le premier, le second et le troisième espaceur latéral peuvent être composés de matériaux similaires, le plot de contact électrique pouvant être en partie formé par la portion du troisième espaceur latéral.

De plus, la cellule mémoire électronique peut comporter en outre au moins une portion de plusieurs autres espaceurs latéraux disposés contre au moins un flanc latéral de plusieurs autres blocs et en contact avec le deuxième espaceur latéral et/ou le troisième espaceur latéral et/ou un desdits autres espaceurs latéraux, et dans laquelle les différents espaceurs latéraux peuvent être composés de matériaux similaires, le plot de contact électrique pouvant être formé par au moins une partie des portions desdits autres espaceurs latéraux. Le nombre de blocs et/ou les dimensions des blocs peuvent être choisis en fonction des dimensions souhaitées du plot de contact électrique.

Le premier et le second bloc peuvent être alignés l'un par rapport à l'autre selon une direction perpendiculaire à une direction source-drain.

Le premier espaceur latéral peut être disposé contre l'ensemble des flancs latéraux de la première grille, et/ou le second espaceur latéral peut être disposé contre l'ensemble des flancs latéraux du bloc, et/ou, lorsque le plot de contact électrique est formé par le deuxième et un troisième espaceur latéral, le troisième espaceur latéral peut être disposé contre l'ensemble des flancs latéraux du second bloc, et/ou, lorsque le plot de contact électrique est formé par au moins une partie des portions desdits autres espaceurs latéraux, lesdits autres espaceurs latéraux peuvent être disposés contre l'ensemble des flancs latéraux desdits autres blocs.

L'invention concerne également un procédé de réalisation d'une cellule mémoire électronique comprenant au moins les étapes de :
- réalisation, dans une couche de semi-conducteur, d'une zone active comportant un canal disposé entre une source et un drain,
- réalisation d'une première grille disposée au moins sur une première partie du canal et d'au moins un bloc disposé sur la couche de semi-conducteur,
- dépôt d'une pluralité de couches de matériaux destinées à former au moins une seconde grille sur au moins une seconde partie du canal, lesdites couches de matériaux recouvrant au moins la couche de semi-conducteur, la zone active, la première grille et le bloc,
- gravure anisotrope desdites couches de matériaux telle qu'une première portion restante desdites couches de matériaux forme un premier espaceur latéral disposé contre des flancs latéraux de la première grille, une partie du premier espaceur latéral formant la seconde grille, et telle qu'une deuxième portion restante desdites couches de matériaux forme un deuxième espaceur latéral disposé contre des flancs latéraux du bloc et en contact avec le premier espaceur latéral, une portion du second espaceur latéral formant au moins une partie d'un plot de contact électrique relié électriquement à la seconde grille,
   l'une de la première ou de la seconde grille comportant un empilement de couches dont au moins une desdites couches est apte à stocker des charges électriques.

La pluralité de couches de matériaux destinées à former la seconde grille peut comprendre au moins une couche électriquement conductrice disposée sur au moins une couche diélectrique.

Le bloc et la première grille peuvent être réalisés à partir des mêmes couches de matériaux.

Lors de la réalisation de la première grille, un second bloc peut également être réalisé sur la couche de semi-conducteur, l'étape de gravure anisotrope pouvant former également un troisième espaceur latéral disposé contre des flancs latéraux du second bloc, au moins une portion du troisième espaceur latéral pouvant être en contact avec le deuxième espaceur latéral et formant au moins une partie du plot de contact électrique.

Lors de la réalisation de la première grille, plusieurs autres blocs peuvent également être réalisés sur la couche de semi-conducteur, et dans lequel l'étape de gravure anisotrope peut former également plusieurs autres espaceurs latéraux disposés contre des flancs latéraux desdits autres blocs, au moins une portion desdits autres espaceurs latéraux pouvant être en contact avec le deuxième espaceur latéral et/ou le troisième espaceur latéral et/ou un desdits autres espaceurs latéraux, le plot de contact électrique pouvant être formé par au moins une partie des portions desdits autres espaceurs latéraux.

Le procédé peut comporter en outre, après la gravure anisotrope desdites couches de matériaux, la mise en oeuvre d'une photolithographie et d'une gravure du premier et/ou du deuxième et/ou du troisième espaceur latéral et/ou desdits autres espaceurs latéraux, telles que des portions restantes du premier et/ou du deuxième et/ou du troisième espaceur latéral et/ou desdits autres espaceurs latéraux peuvent former la seconde grille et le plot de contact électrique.

Lorsque la seconde grille comporte ledit empilement de couches, le second espaceur latéral peut être formé d'une partie des couches dudit empilement.

L'invention concerne également un dispositif mémoire comportant une pluralité de cellules mémoires telles que décrites précédemment et disposées en matrice et reliées électriquement entre elles selon une architecture de type NOR.

Les deuxièmes espaceurs latéraux de deux cellules mémoires adjacentes peuvent être disposés contre deux flancs latéraux opposés d'un bloc commun aux deux cellules mémoires adjacentes.

Dans une autre variante, lorsque les plots de contacts électriques de deux cellules mémoires adjacentes sont formés par des deuxièmes et des troisièmes espaceurs latéraux, lesdits troisièmes espaceurs latéraux peuvent être disposés contre deux flancs latéraux opposés d'un second bloc commun aux deux cellules mémoires adjacentes.

Enfin, l'invention concerne également un procédé de réalisation d'un dispositif mémoire comportant au moins les étapes de :
- réalisation d'une pluralité de cellules mémoires disposées en matrice, comportant, pour la réalisation d'au moins une cellule mémoire de chaque colonne de la matrice, la mise en ouvre d'un procédé de réalisation tel que décrit précédemment,
- réalisation d'interconnexions électriques de la pluralité de cellules mémoire telles que les cellules mémoires soient reliées électriquement entre elles selon une architecture de type NOR.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels .
- les figures 1A à 10 représentent les étapes d'un procédé de réalisation d'une cellule mémoire, objet de la présente invention, selon un premier mode de réalisation,
- les figures 2A à 2C représentent une cellule mémoire, objet de la présente invention, selon un seconde mode de réalisation,
- les figures 3, 4A et 4B représentent une cellule mémoire, objet de la présente invention, selon des variantes des premiers et seconds modes de réalisation,
- les figures 5 à 12B représentent des dispositifs mémoires, également objets de la présente invention, réalisés selon différentes variantes de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

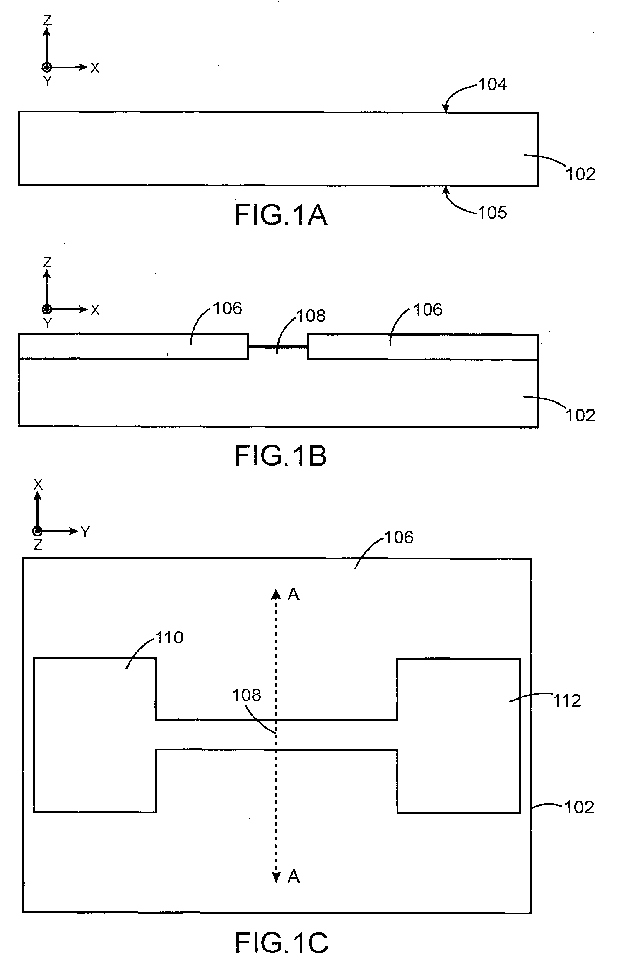

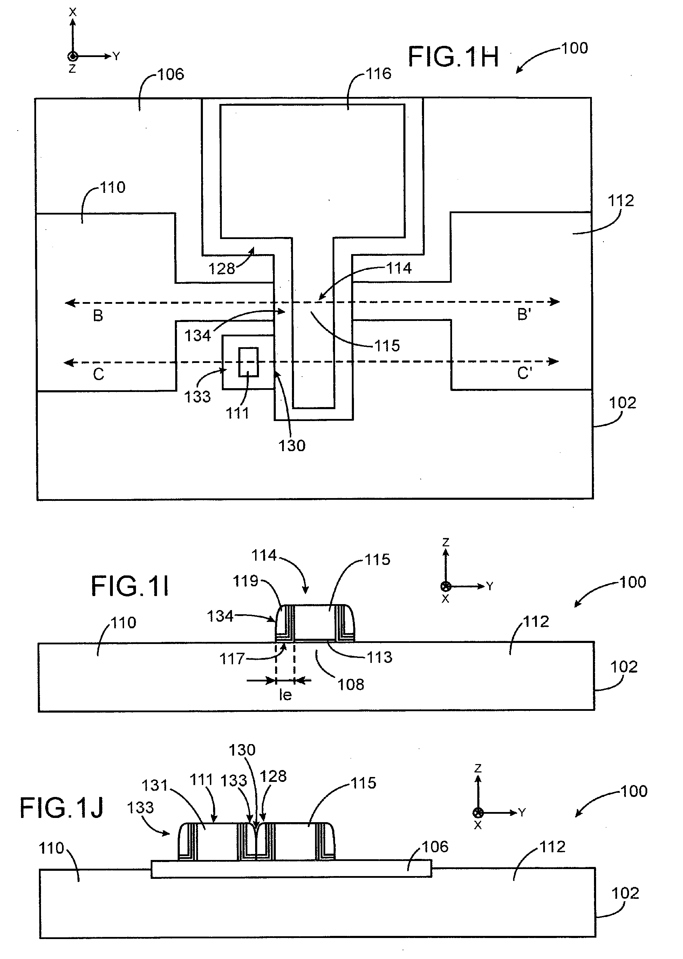

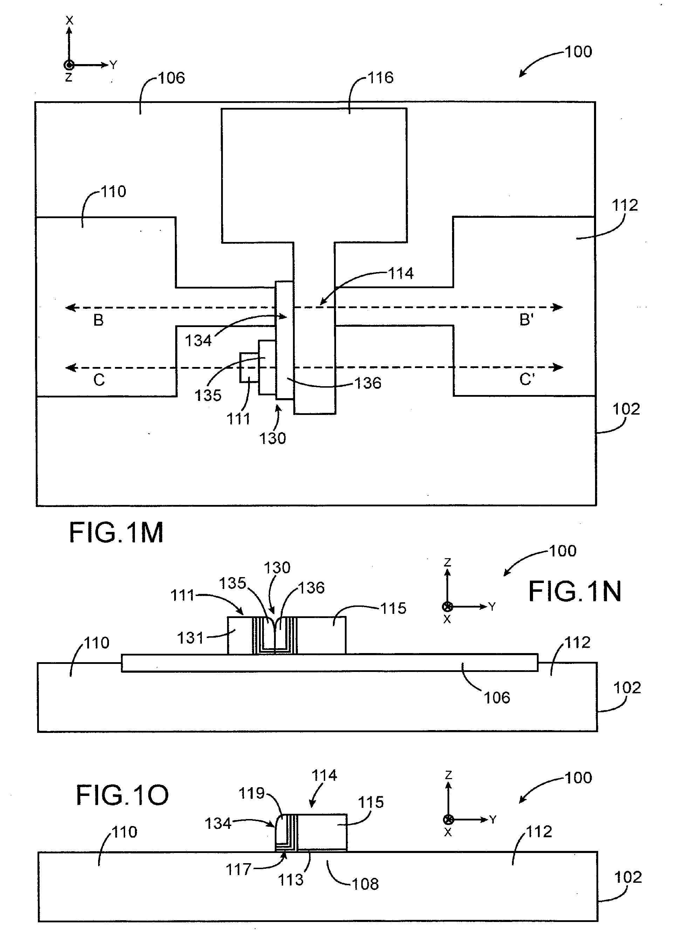

On se réfère tout d'abord aux figures 1A à 10 qui représentent les étapes d'un procédé de réalisation d'une cellule mémoire 100 selon un premier mode de réalisation.

Comme représenté sur la figure 1A, la cellule mémoire 100 est réalisée à partir d'un substrat 102, par exemple à base d'un semi-conducteur tel que du silicium, comportant une face principale avant 104 et une face principale arrière 105.

Une zone active de la cellule mémoire 100 est tout d'abord délimitée dans le substrat 102 en réalisant des tranchées d'isolation, par exemple de type STI (« Shallow Trench Isolation »), formées dans le substrat 102, depuis la face avant 104, puis remplies par un matériau diélectrique, délimitant ainsi la zone active d'une zone d'isolation 106 (voir les figures 1B et 1C, la figure 1B étant une vue en coupe selon un axe AA représenté sur la figure 1C). La zone active comporte trois régions 108, 110 et 112, respectivement destinées à former un canal, une source et un drain de la cellule mémoire 100.

On réalise ensuite une première des deux grilles de la cellule mémoire qui servira par la suite pour la réalisation de l'autre grille sous la forme d'un espaceur latéral. Dans le premier mode de réalisation décrit ici, cette première grille correspond à la grille de commande de la cellule mémoire 100.

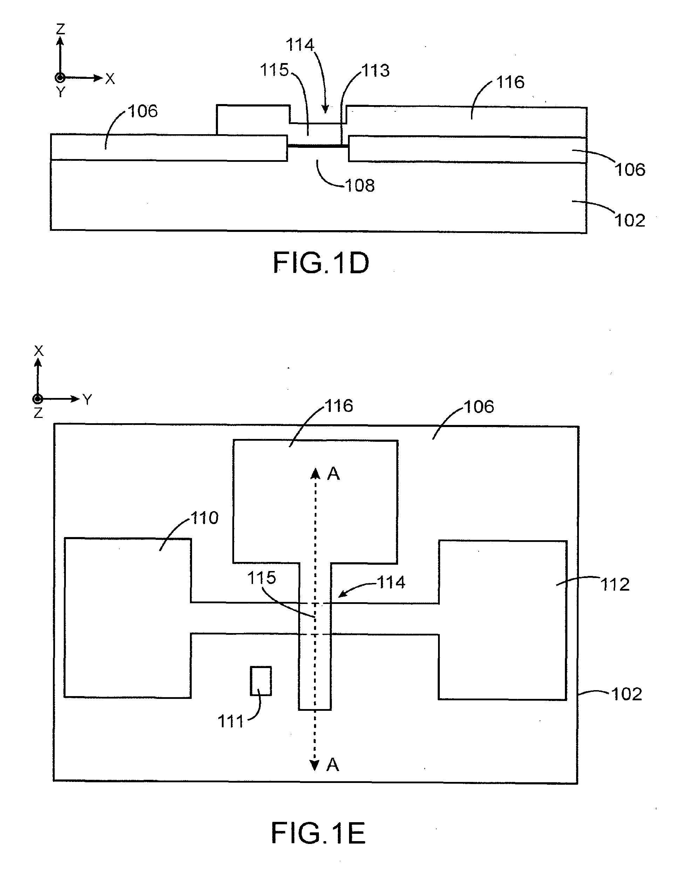

Pour cela, une couche de matériau diélectrique, par exemple de l'oxyde de silicium, est formée, par exemple par oxydation thermique, sur la zone active. L'épaisseur de cette couche de matériau diélectrique dépend du noeud technologique de la cellule mémoire 100, et est par exemple comprise entre environ 1 nm et 10 nm. On réalise ensuite un dépôt d'une couche électriquement conductrice composée d'un matériau de grille électriquement conducteur, par exemple du polysilicium dopé n+ d'épaisseur (dimension selon l'axe z représenté sur les figures 1D et 1E) égale à environ 50 nm et déposée de manière conforme sur la couche diélectrique précédemment formée et sur la zone d'isolation 106.

Une photolithographie et une gravure de la couche de matériau de grille et de la couche diélectrique sont ensuite mises en oeuvre afin de former une première grille 114 comprenant une portion 115 du matériau de grille recouvrant un diélectrique de grille 113 disposé sur une première partie du canal 108 et destinée à former la grille de commande de la cellule mémoire 100 (figures 1D et 1E). Cette photolithographie et cette gravure sont également réalisées telles que la première grille 114 peut comporter un plot de contact électrique 116 composé du matériau de grille, et de dimensions plus importantes (dans le plan (X,Y)) que celles de la portion 115, et qui servira de surface de reprise de contact électrique de la première grille 114. Toutefois, il est possible de ne pas former ce plot de contact électrique 116, la reprise de contact électrique s'effectuant alors directement sur la portion 115, ou bien de former un plot de contact électrique 116 dont les dimensions correspondent à celles de la portion 115, formant alors un prolongement de la portion 115 au niveau de la zone d'isolation 106.

Ces étapes de photolithographie et de gravure forment également, à proximité de la première grille 114, un bloc 111 disposé sur la zone d'isolation 106. Ce bloc 111 est formé d'une portion de la couche de matériau de grille gravée. Ce bloc 111 servira par la suite pour la réalisation d'un plot de contact électrique 130 de la seconde grille 134.

On met ensuite en oeuvre des étapes afin de réaliser une seconde grille 134 destinée à être disposée sur une seconde partie du canal 108 et à former une grille de mémorisation de la cellule mémoire 100, et réaliser un plot de contact électrique 130 de cette seconde grille 134.

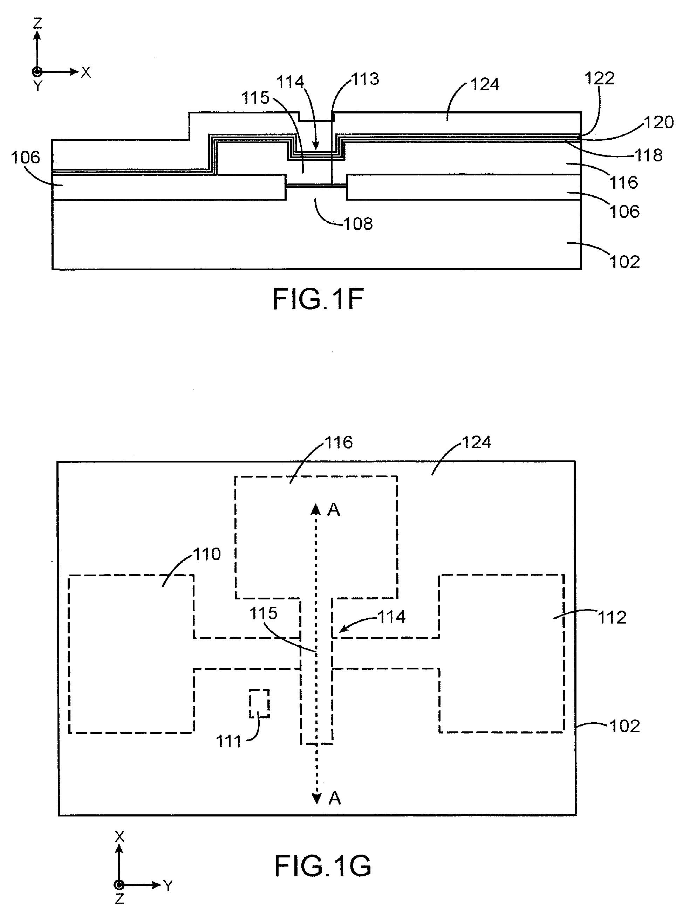

Pour cela, on réalise tout d'abord une première couche 118 composée d'un matériau diélectrique, par exemple de l'oxyde de silicium, destinée à former un oxyde tunnel de la seconde grille 134. Cette première couche 118 est réalisée de manière conforme sur la zone active, sur la première grille 114 et sur le bloc 111, par exemple par oxydation thermique. Cette première couche diélectrique 118 est recouverte d'une deuxième couche 120 composée d'un matériau apte à stocker des charges électriques et destinée à former la couche de mémorisation. Cette deuxième couche 120, par exemple composée de nitrure de silicium, est également réalisée de manière conforme sur la première couche diélectrique 118, par exemple par la mise en oeuvre d'un dépôt CVD (dépôt chimique en phase vapeur), et sur la zone d'isolation 106. La deuxième couche 120 est ensuite recouverte d'une troisième couche 122 composée d'un matériau diélectrique, par exemple de l'oxyde de silicium. Cette troisième couche diélectrique 122 est également réalisée de manière conforme sur la deuxième couche 120, par exemple par CVD basse pression et oxydation thermique. Enfin, la troisième couche diélectrique 122 est recouverte par une couche 124 composée d'un matériau de grille électriquement conducteur, par exemple du polysilicium dopé n+, et par exemple d'épaisseur (dimension selon l'axe z) égale à environ 50 nm. Cette couche 124 est également déposée de manière conforme sur la troisième couche diélectrique 122 (figures 1F et 1G). La première couche diélectrique 118 a par exemple une épaisseur comprise entre environ 4 nm et 8 nm, la deuxième couche 120 a par exemple une épaisseur comprise entre environ 4 nm et 10 nm, et la troisième couche 122 a par exemple une épaisseur comprise entre environ 4 nm et 15 nm. Dans une variante, il est possible de ne pas réaliser la troisième couche 122. Dans ce cas, l'épaisseur de la deuxième couche 120 peut être au moins égale à environ 10 nm.

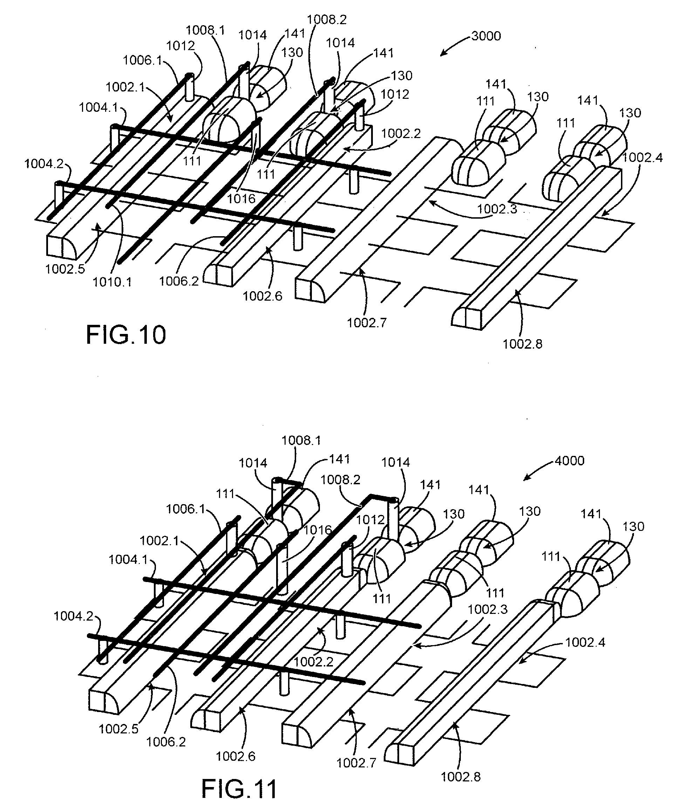

Les couches 118, 120, 122 et 124 précédemment réalisées sont ensuite gravées de manière anisotrope, par exemple par une gravure sèche de type RIE (gravure ionique réactive), avec arrêt sur la zone active, sur la zone d'isolation 106, sur la première grille 114 et sur le bloc 111. Cette étape de gravure est mise en oeuvre sans faire appel à un masque de gravure et sans étape ultérieure de sur-gravure (« over-edge »). Du fait qu'aucune étape de sur-gravure est mise en oeuvre, des espaceurs latéraux formés de portions restantes de chacune des couches 118, 120, 122 et 124 sont conservés autour des zones à forte topographie. Ainsi, un premier espaceur latéral 128 est formé autour de la première grille 114, contre les flancs latéraux de la première grille 114 (voir figures 1H, 11 et 1J, les figures 11 et 1J étant des vues en coupe respectivement selon des axes BB et CC représentés sur la figure 1H). De plus, étant donné que chacune des couches gravées avait été déposée de manière conforme, chacune des portions restantes de ces couches du premier espaceur latéral 128 a donc une partie disposée en regard d'un flanc latéral de la première grille 114 et une autre partie disposée en regard du canal 108. Ainsi, les portions restantes des couches 118, 120 et 122 disposées en regard des flancs latéraux de la première grille 114 assurent l'isolation électrique entre le matériau de grille de la première grille 114 et la portion restante de la couche de matériau de grille 124 du premier espaceur.

Une portion du premier espaceur 128 se trouvant au-dessus du canal 108 forme la seconde grille 134. La fonction de mémorisation de la seconde grille 134 sera assurée par les portions restantes des couches 118, 120 et 122 se trouvant au-dessus du canal 108, formant un empilement mémoire 117. L'empilement mémoire 117 est recouvert d'une portion restante 119 de la couche électriquement conductrice 124.

Cette étape de gravure forme également autour du plot 111 qui, comme représenté sur la figure 1J, est formé par une portion 131 du matériau de grille de la première grille 114, un deuxième espaceur 133 formé des mêmes matériaux que le premier espaceur 128.

La distance entre le bloc 111 et la première grille 114 est choisie afin que le premier espaceur 128 et le deuxième espaceur 133 soient en contact (physiquement et électriquement) l'un avec l'autre. Ainsi, les portions des espaceurs 128 et 133 en contact l'une avec l'autre forment un plot de contact électrique 130 destiné à réaliser une reprise de contact électrique de la seconde grille 134.

La largeur le du premier espaceur 128, au niveau de la première grille 134, est sensiblement égale à la somme des épaisseurs des couches à partir desquelles le premier espaceur 128 est réalisé. Le premier espaceur 128 a par exemple une largeur le comprise entre environ 20 nm et 150 nm. De plus, la largeur le du premier espaceur 128 est sensiblement égale à la largeur du deuxième espaceur 133. En fonction de la largeur souhaitée de la seconde grille 134, qui correspond à la largeur le de l'espaceur 128, on choisira des épaisseurs adéquates des couches 118, 120, 122 et 124 afin d'aboutir à un espaceur 128 de largeur désirée. La largeur de la seconde grille 134 sera notamment calculée par exemple par l'intermédiaire d'un logiciel de calcul numérique à partir de la largeur du canal 108, de la longueur de la première grille 114, de la profondeur des implantations réalisées, etc. Les simulations peuvent être réalisées à partir d'un logiciel de simulation TCAD, comme Silvaco ou Synopsys.

Une telle simulation est réalisée en fixant d'abord le noeud technologique (donc les longueurs de grille) puis en simulant les caractéristiques statiques des transistors Id(Vg1) Id(Vg2) en fonction des paramètres des transistors : épaisseur du diélectrique du transistor de sélection, dopage du canal du transistor de sélection, dopage du canal du transistor mémoire, dopage des extensions LDD, dopage des source/drain. On contrôle ainsi les valeurs des tensions de seuil et on limite les effets de canal court et de drain disturb. Une étude dynamique peut également être menée à partir de simulations Monte Carlo, comme décrit par exemple dans le document « Monte Carlo simulation of substrate enhanced electron injection in split-gate memory cells » de W. Stefanutti et al., IEEE Trans. On Elec. Dev., 53, 1, pages 89-96, 2006, afin d'évaluer l'impact des paramètres des transistors et des longueurs de grille sur les performances mémoire.

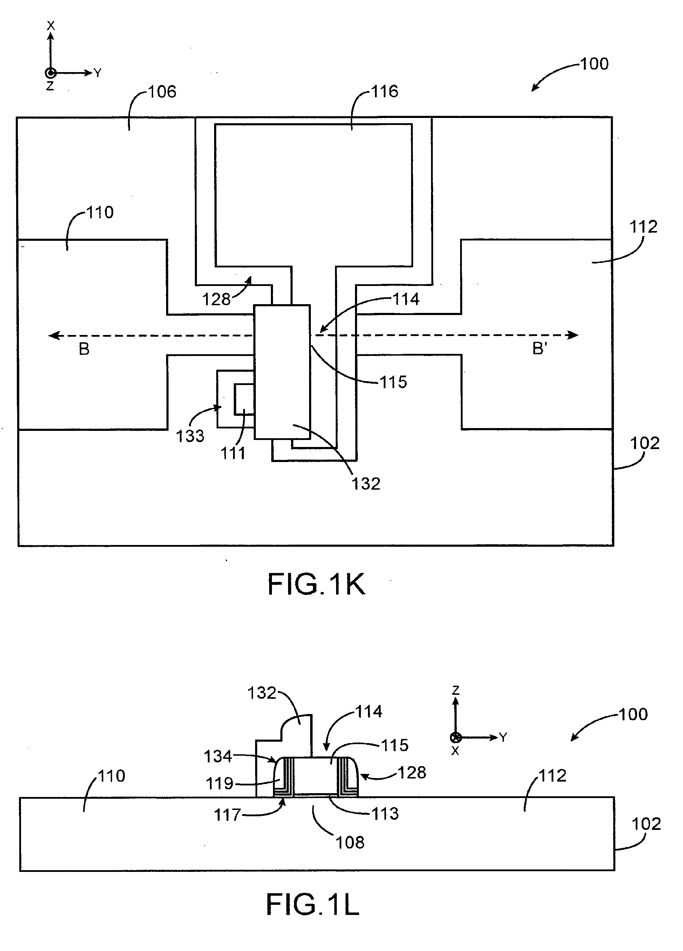

Des étapes de photolithographie et de gravure peuvent ensuite être mises en ouvre afin de supprimer certaines parties du premier espaceur 128 et du second espaceur 133, telles qu'une partie d'une portion restante du premier espaceur 128 corresponde à la seconde grille 134, c'est-à-dire la grille de mémorisation de la cellule mémoire 100, et qu'une autre partie de cette portion restante du premier espaceur 128 soit en contact avec le second espaceur 133. Pour cela, on réalise un masque de gravure 132 recouvrant les portions des espaceurs 128, 133 à conserver (figures 1K et 1L). Le masque 132 est réalisé sous la forme d'une seule portion continue de matériau afin d'assurer une continuité électrique entre les portions restantes du premier espaceur 128 et du second espaceur 133, cette continuité assurant un contact électrique entre le plot de contact électrique 130 et la seconde grille 134.

Après cette gravure, le masque 132 est retiré, révélant le plot de contact électrique 130 formé par une portion restante 135 du second espaceur 133 et une partie restante 136 du premier espaceur 128, cette partie restante 136 étant reliée électriquement à la seconde grille 134 (figures 1M, 1N et 10, la figure 1N étant une vue en coupe selon l'axe CC représenté sur la figure 1M et la figure 10 étant une vue en coupe selon l'axe BB représenté sur la figure 1M).

On voit donc que par rapport aux cellules mémoires de l'art antérieur, la surface disponible pour réaliser une reprise de contact électrique de la seconde grille 134 (surface formée par le plot de contact électrique 130, c'est-à-dire les portions d'espaceur 135 et 136) est doublée par rapport à une cellule mémoire dans laquelle la reprise de contact électrique est réalisée uniquement sur un espaceur formant une grille, et cela sans nécessiter la mise en ouvre d'une étape supplémentaire de photolithographie. On relaxe ainsi d'un facteur 2 la tolérance de désalignement lors de la réalisation ultérieure du contact électrique de la seconde grille 134.

De manière analogue aux cellules mémoires de l'art antérieur, la cellule mémoire 100 est ensuite achevée en réalisant notamment, après la gravure de la seconde grille, les implantations LDD, le dépôt et la gravure d'espaceurs en matériau diélectrique, les implantations HDD, une siliciuration de grille, un dépôt d'oxyde de passivation, une photolithographie et une gravure des contacts électriques, un dépôt de matériaux de contact, etc.

Bien que dans ce premier mode de réalisation la seconde grille 134 est disposée à gauche (voir la figure 1M) de la première grille 114 (c'est à dire du côté de la source 110), il est tout à fait possible que la seconde grille 134 soit formée par la partie de l'espaceur 128 disposée sur le canal 108 à droite de la première grille 114 (c'est-à-dire du côté du drain 112). Dans ce cas, le bloc 111 peut être réalisé du côté droit de la première grille 114 afin de former le plot de contact électrique 130 du même côté que la seconde grille 134.

Dans le premier mode de réalisation précédemment décrit, la première grille 114 de la cellule mémoire 100 forme la grille de commande, tandis que la seconde grille 134 forme la grille de mémorisation de la cellule mémoire 100. Toutefois, dans un second mode de réalisation, il est possible que la première grille 114 forme la grille de mémorisation de la cellule mémoire 100 et que la seconde grille 134, qui est réalisée sous la forme d'un espaceur latéral de la première grille 114, forme la grille de commande de la cellule mémoire 100.

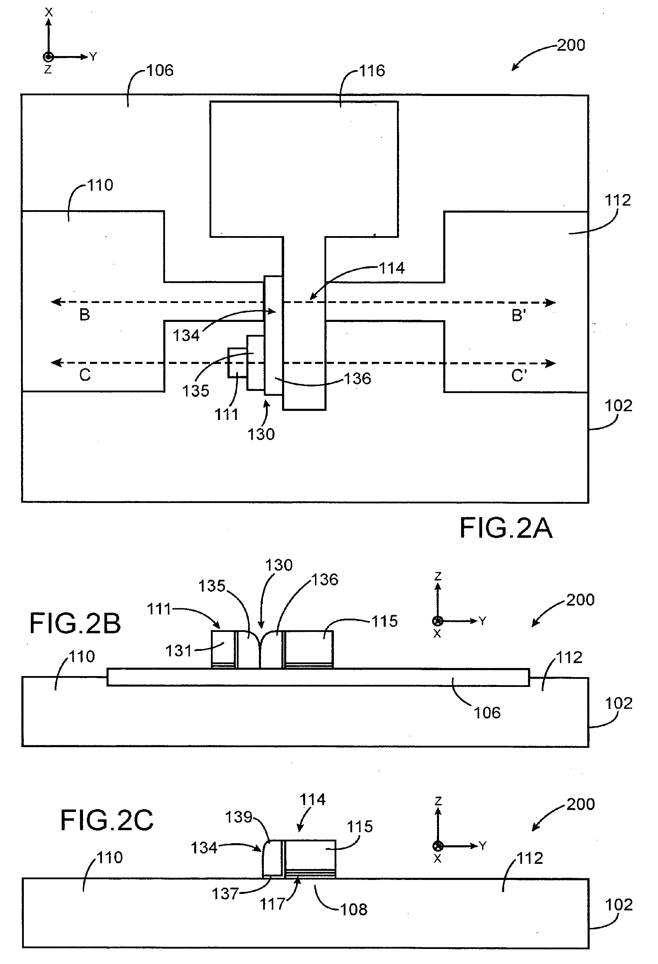

Une cellule mémoire 200 selon ce second mode de réalisation est représentée sur les figures 2A à 2C (les figures 2B et 2C représentant respectivement des vues en coupe selon les axes CC et BB représentés sur la figure 2A). Par rapport à la cellule mémoire 100 précédemment décrite, la première grille 114 de cette cellule mémoire 200 forme la grille de mémorisation de la cellule mémoire 200 tandis que la seconde grille 134 forme la grille de commande de la cellule mémoire 200.

Cette première grille 114 est donc réalisée à partir d'un empilement de couches par exemple de natures similaires aux couches 118, 120, 122 et 124 utilisées pour réaliser la seconde grille 134 de la cellule mémoire 100. Ainsi, dans ce second mode de réalisation, la première grille 114 ne comporte pas le diélectrique de grille 113 mais un empilement mémoire 117 formé de portions gravées des couches 118, 120 et 122 selon un motif conforme à celui de la première grille 114 (ce motif étant similaire à celui de la première grille 114 de la cellule mémoire 100), cet empilement mémoire 117 étant surmonté de la portion électriquement conductrice 115. Une partie de cet empilement mémoire 117 (c'est-à-dire toutes les portions de l'empilement 117 sauf la portion de la couche 118) se retrouve également sous la portion de matériau électriquement conducteur 115, au niveau de la zone d'isolation 106, et au niveau du bloc 111, sous la portion de matériau de grille 131 puisque le bloc 111 est réalisé à partir des même couches que celles utilisées pour réaliser la première grille 114.

Dans ce second mode de réalisation, comme pour le premier mode de réalisation, la seconde grille 134 forme une portion d'un espaceur latéral disposé contre un flanc latéral de la première grille 114.

Toutefois, contrairement au premier mode de réalisation, cette seconde grille 134 ne comporte pas d'empilement mémoire (celui-ci étant déjà formé au niveau de la première grille 114) mais comporte un diélectrique de grille 137 surmonté d'une portion 139 de matériau électriquement conducteur, formant la grille de commande de la cellule mémoire 200. Ces matériaux formant la seconde grille 134 se retrouvent dans les éléments formant le plot de contact électrique 130, c'est-à-dire la portion d'espaceur 136 formant une portion continue avec la seconde grille 134, et la portion d'espaceur 135 disposée contre le bloc 111.

Dans une variante de réalisation des cellules mémoires 100 et 200, il est possible de ne pas réaliser les étapes de photolithographie et de gravure décrites en liaison avec les figures 1K à 10. En effet, il est tout à fait possible de réaliser une reprise de contact électrique de la seconde grille 134 à partir des espaceurs 128 et 133 disposés tout autour de la première grille 114 et du bloc 111. Une telle cellule mémoire 100 correspond à la cellule mémoire représentée sur les figures 1H, 11 et 1J. Dans une telle configuration, la mémorisation de donnée peut être réalisée dans une seule portion de la seconde grille 134, d'un côté ou de l'autre de la première grille 114, l'autre portion servant alors d'élément du transistor d'accès, ou bien dans les deux portions de l'espaceur 128, de chaque côté de la première grille 114. Une telle configuration permet également de réaliser une mémoire à multi-bit à condition de contacter indépendamment les deux espaceurs latéraux dans lesquels une mémorisation peut être réalisée. Si les espaceurs sont connectés au même potentiel, des modes d'écriture particuliers peuvent adresser chaque couche de piégeage des deux espaceurs latéraux.

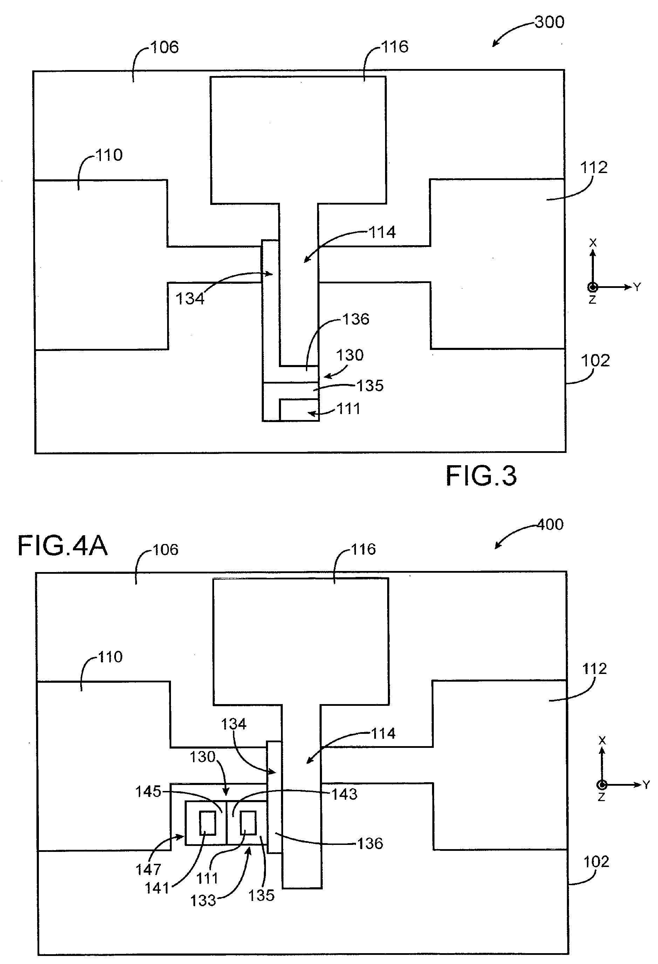

Une autre variante de réalisation d'une cellule mémoire 300 est représentée sur la figure 3.

Par rapport aux cellules mémoires 100, 200 précédemment décrites, le plot de contact électrique 130 est ici réalisé dans le prolongement de la première grille 114.

Ainsi, le bloc 111 est disposé dans le prolongement de la première grille 114 selon l'axe x représenté sur la figure 3. Dans cette variante, une portion restante du premier espaceur latéral, formant la seconde grille 134 ainsi qu'une portion 136 reliée électriquement à la seconde grille 134, est donc disposée contre deux flancs latéraux de la première grille 114 distincts et perpendiculaires l'un par rapport à l'autre. Le plot de contact électrique 130 est ici formé par cette portion d'espaceur 136 et la portion d'espaceur 135 formée contre le plot 111, et est disposé dans le prolongement de la première grille 114 selon l'axe x représenté sur la figure 3.

Une telle variante de réalisation a notamment pour avantage de pouvoir rapprocher les lignes électriquement conductrices destinées à être réalisées pour contacter la première grille 114 et la seconde grille 134, permettant ainsi d'augmenter la densité d'un dispositif mémoire formé d'une matrice de cellules mémoires 300. Cette variante peut s'appliquer aussi bien à la cellule mémoire 100 qu'à la cellule mémoire 200.

Une autre variante de réalisation d'une cellule mémoire 400 est représentée sur la figure 4A.

Par rapport aux cellules mémoires 100 et 200 précédemment décrites, les portions d'espaceur 135 et 136 ne servent pas directement de surface de reprise de contact électrique. En effet, un second bloc 141, par exemple similaire au bloc 111, est réalisé à côté du bloc 111, par exemple à partir des couches servant à réaliser la première grille 114 et le premier bloc 111. Dans le cas présent, le premier bloc 111 et le second bloc 141 sont alignés l'un par rapport à l'autre selon une direction parallèle à la direction source-drain (parallèle à l'axe y). La distance entre les blocs 111 et 141 est par exemple égale à la distance séparant le bloc 111 et la première grille 114. Dans cette variante de réalisation, la mise en oeuvre de l'étape de gravure anisotrope formant les espaceurs 128 et 133 forme également un troisième espaceur 147 autour du second bloc 141. On voit sur la figure 4A que le second espaceur 133 comporte une portion 135 en contact avec la portion d'espaceur 136 qui est reliée électriquement à la seconde grille 134 et, contre un flanc latéral opposé à celui contre lequel repose la portion 135, une autre portion 143 de ce second espaceur 133. De plus, une portion 145 du troisième espaceur 147 formé autour du second bloc 141 est en contact contre la portion 143, ces portions 143 et 145 formant le plot de contact électrique 130, c'est-à-dire la surface de reprise de contact électrique sur laquelle un contact électrique sera ensuite réalisé, cette surface étant reliée électriquement à la seconde grille 134 par l'intermédiaire des portions d'espaceur 135 et 136.

Par rapport aux cellules mémoires précédemment décrites, cette cellule mémoire 400 permet de supprimer le risque d'un éventuel court-circuit pouvant apparaître entre la première grille 114 et la seconde grille 134 lors de la réalisation du contact électrique de la seconde grille 134 en cas de désalignement important du contact, car les blocs 111 et 141 ne sont pas en contact électrique avec la première grille 114 et sont éloignés de la première grille 114.

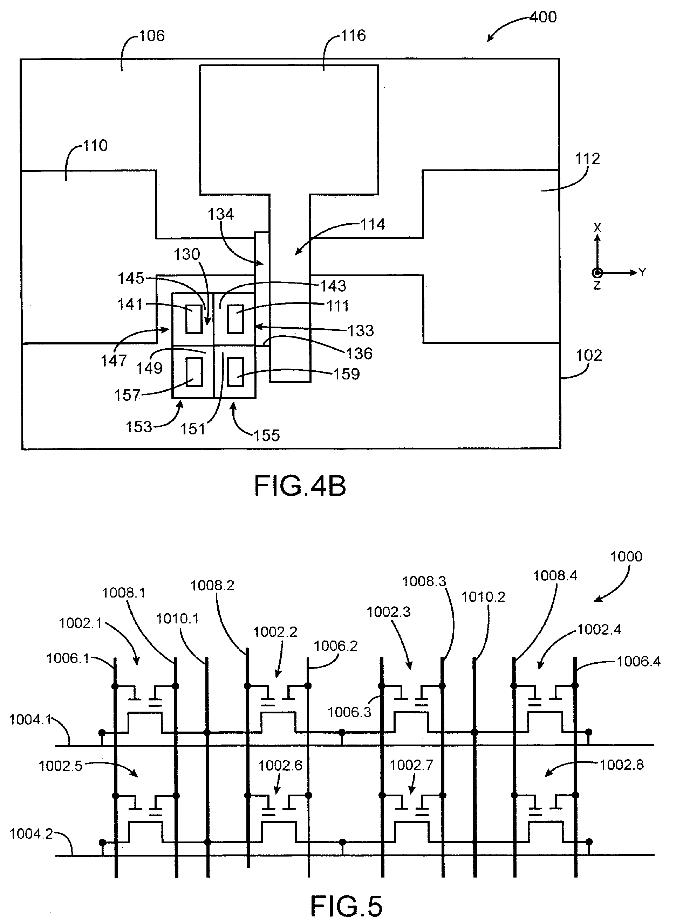

Une autre variante de réalisation de la cellule mémoire 400 est représentée sur la figure 4B.

Par rapport à la cellule mémoire 400 précédemment décrite en liaison avec la figure 4A, le plot de contact électrique 130 est formé par les portions 145 et 143 des espaceurs 133 et 147, mais également par des portions 149 et 151 de deux autres espaceurs 153 et 155 en contact avec les espaceurs 133 et 147 et formés autour de deux autres blocs 157 et 159.

De manière générale, il est possible de former n blocs autour desquels des espaceurs vont former une partie du contact électrique 130, avec n entier supérieur ou égal à 1.

Les cellules mémoires 100 ou 200 précédemment décrites sont destinées à être intégrées en grand nombre sous la forme de matrices pour former des dispositifs mémoires de type Flash. Un exemple d'une partie d'un tel dispositif mémoire 1000 est représenté, de manière schématique, sur la figure 5.

Le dispositif mémoire 1000 est formé d'une pluralité de cellules mémoires 1002, dont certaines sont similaires aux cellules mémoires 100 ou 200 précédemment décrites, disposées en matrice, c'est-à-dire en lignes et en colonnes. Sur la figure 5, seules 8 cellules mémoires 1002.1 à 1002.8 sont représentées.

Toutefois, le dispositif mémoire 1000 comporte en réalité plusieurs milliers ou millions de cellules mémoires similaires aux cellules mémoires 1002.1 - 1002.8 et toutes reliées électriquement entre elles comme représenté sur la figure 5, sous la forme d'une seule matrice ou sous la forme de plusieurs blocs. Les 8 cellules mémoires 1002.1 - 1002.8 8 peuvent être vues comme un « élément mémoire de base » qui est répété plusieurs milliers ou millions de fois, à la fois en lignes et en colonnes, pour former le dispositif mémoire 1000.

Sur l'exemple de la figure 5, les cellules mémoires 1002 sont reliées électriquement entre elles conformément à une architecture de type NOR (ou NON-OU), c'est-à-dire dans laquelle chaque cellule mémoire 1002 de la matrice peut être adressée individuellement.

Dans une variante, il est envisageable de réaliser une architecture de type NAND.

Dans cette configuration de type NOR, les drains de chaque cellule mémoire 1002 d'une même ligne sont tous reliés à une ligne électriquement conductrice 1004, appelée ligne de bits, permettant d'adresser les cellules mémoires se trouvant sur cette ligne. Sur l'exemple de la figure 5, les drains des cellules mémoires 1002.1 à 1002.4 sont reliés à une première ligne de bits 1004.1. De même, les drains des cellules mémoires 1002.5 à 1002.8 sont reliés à une seconde ligne de bits 1004.2.

Le dispositif mémoire 1000 comporte également des lignes électriquement conductrices 1006, appelées lignes de mots, chacune des grilles de commande des cellules mémoires d'une même colonne étant reliées électriquement à une même ligne de mots 1006.

Ainsi, sur l'exemple de la figure 5, les grilles de commande des cellules mémoires 1002.1 et 1002.5 sont reliées électriquement à une première ligne de mots 1006.1. De même, les grilles de commande des cellules mémoires 1002.2 et 1002.6, 1002.3 et 1002.7, et 1002.4 et 1002.8 sont respectivement reliées à des lignes de mots 1006.2, 1006.3 et 1006.4.

De manière analogue, les grilles de mémorisation des cellules mémoires d'une même colonne sont toutes reliées électriquement à une ligne électriquement conductrice appelée ligne de mémorisation. Ainsi, sur l'exemple de la figure 5, les grilles de mémorisation des cellules mémoires 1002.1 et 1002.5, 1002.2 et 1002.6, 1002.3 et 1002.7, et 1002.4 et 1002.8 sont respectivement reliées à des lignes de mémorisation 1008.1, 1008.2, 1008.3 et 1008.4.

Enfin, la mémoire 1000 comporte également des lignes électriquement conductrices 1010, appelées lignes de sources, reliées électriquement aux sources des cellules mémoires de deux colonnes adjacentes.

Ainsi, les sources des cellules 1002.1, 1002.2, 1002.5 et 1002.6 sont reliées électriquement à une première ligne de sources 1010.1, et les sources des cellules 1002.3, 1002.4, 1002.7 et 1002.8 sont reliées électriquement à une seconde ligne de sources 1010.2.

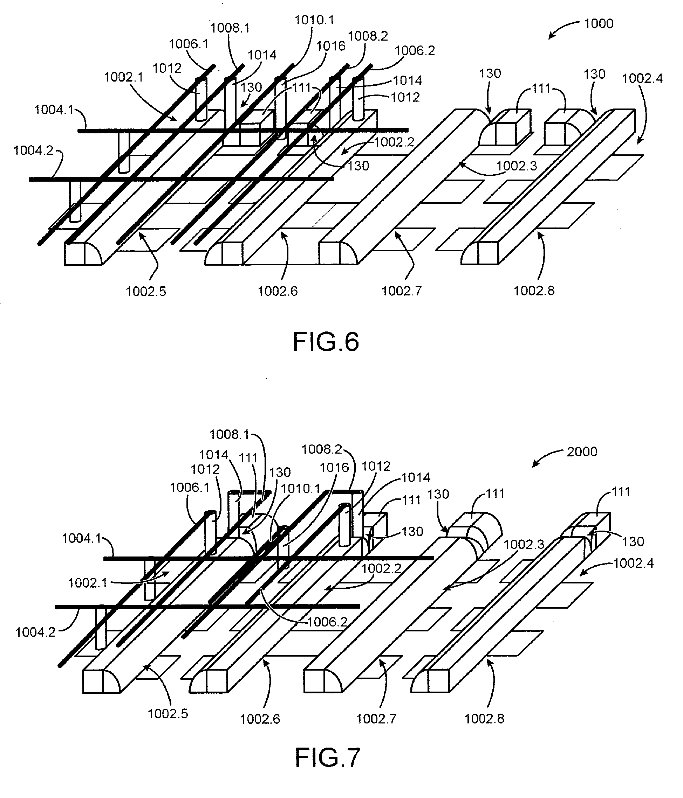

La figure 6 est une vue en 3 dimensions simplifiée des 8 cellules mémoires 1002.1 - 1002.8 représentées sur la figure 5. Sur cette figure 6, seule une partie des lignes d'interconnexions électriques sont représentées. Les cellules mémoires 1002.1 - 1002.8 sont ici sensiblement similaires à la cellule mémoire 100 précédemment décrite, c'est-à-dire comportent une grille de mémorisation formant un espaceur latéral de la grille de commande. Sur l'exemple de la figure 6, on voit également que les grilles (aussi bien les grilles de commande que les grilles de mémorisation) des cellules disposées sur une même colonne sont formées par des portions continues de matériaux pour l'ensemble des cellules mémoires de la colonne. Ainsi, il est possible de réaliser les cellules mémoires d'une même colonne telle qu'une seule de ces cellules mémoires (par exemple celle se trouvant en haut de la colonne, c'est-à-dire les cellules mémoires 1002.1 - 1002.4 sur l'exemple de la figure 6) comporte un plot de contact électrique (non représenté sur la figure 4) permettant de relier électriquement la ligne de mots 1006 aux première grilles 114 de commande des cellules mémoires de cette colonne par l'intermédiaire d'un contact électrique 1012, et un plot de contact électrique 130 permettant de relier électriquement la ligne de mémorisation 1008 aux secondes grilles 134 de mémorisation des cellules mémoires de cette colonne par l'intermédiaire d'un contact électrique 1014.

De plus, sur l'exemple de la figure 6, un seul contact électrique 1016 relie les sources de l'ensemble des cellules mémoires de deux colonnes adjacentes à la ligne de source correspondante.

Toutefois, dans une variante de réalisation, afin de réduire les résistances d'accès aux sources, il est possible que plusieurs contacts électriques soient réalisés, par exemple un au niveau de chaque ligne de cellules mémoires, pour relier ces sources à la ligne de source 1010.

Sur l'exemple de la figure 6, les lignes de bits 1004.1, 1004.2, formant des lignes électriquement conductrices s'étendant horizontalement, sont réalisées au sein d'un premier niveau de métallisation, tandis que les autres lignes électriquement conductrices s'étendant verticalement (lignes de sources, lignes de mots et lignes de mémorisation) sont réalisées au sein d'un second niveau de métallisation superposé au premier niveau de métallisation. De plus, la réalisation des contacts électriques est par exemple obtenue en recouvrant les cellules mémoires par une couche diélectrique, puis en réalisant une gravure des emplacements des contacts électriques dans la couche diélectrique, puis en remplissant ces emplacements par un métal, formant ainsi les contacts électriques. Les lignes électriquement conductrices sont ensuite réalisées sur cette couche diélectrique et superposées entre différents niveaux de matériaux diélectriques.

Lorsque l'on souhaite obtenir une forte densité des cellules mémoires 1002, il est possible de réaliser le dispositif mémoire 1000 tel que les contacts 1012, 1014 et 1016 soient décalés et proches les uns des autres afin de minimiser l'espace nécessaire à la réalisation de ces contacts électriques.

De plus, il est également possible d'élargir les lignes de mots 1006 et/ou les lignes de mémorisation 1008 et/ou les lignes de sources 1010 afin de faciliter la reprise de contact électrique sur les cellules mémoires 1002. Un tel élargissement est défini lors de l'étape de photolithographie, où une ligne élargie est réalisée plutôt qu'une ligne uniforme.

Un dispositif mémoire 2000 selon un autre mode de réalisation est représenté sur la figure 7. Par rapport au dispositif mémoire 1000 précédemment décrit, les cellules mémoires 1002 de ce dispositif mémoire 2000 sont ici sensiblement similaires à la cellule mémoire 300 précédemment décrite en liaison avec la figure 3, c'est-à-dire comportent un plot de contact électrique 130 formé dans le prolongement de la première grille 114. Ainsi, par rapport au dispositif mémoire 100, il est possible de rapprocher les lignes de mots 1006 et les lignes de mémorisation 1008, et augmenter ainsi la densité d'intégration des cellules mémoires 1002 au sein du dispositif mémoire 2000.

Toutefois, afin de ne pas court-circuiter, au sein d'une colonne, la ligne de mot 1006 avec la ligne de mémorisation 1008, cette dernière est décalée latéralement par rapport à la ligne de mot 1006.

Là encore, il est possible d'élargir les lignes de mots 1006 et/ou les lignes de mémorisation 1008 et/ou les lignes de sources 1010 afin de faciliter la reprise de contact électrique sur les cellules mémoires 1002.

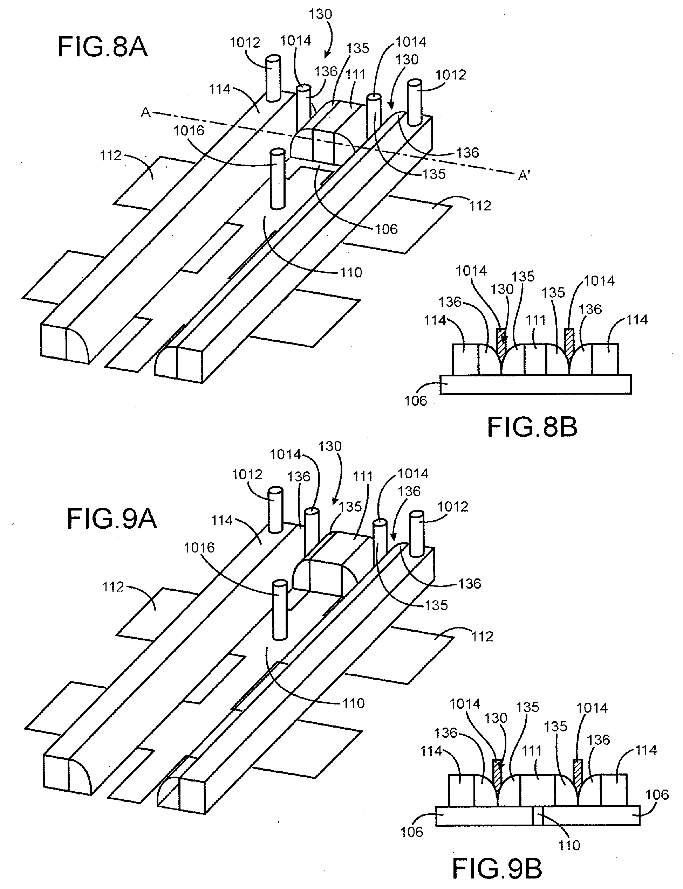

Dans un autre mode de réalisation, il est possible de réaliser les cellules mémoires d'un dispositif mémoire telles que les portions d'espaceur 135 servant à former les plots de contact électriques 130 de deux cellules mémoires adjacentes reposent sur les flancs latéraux d'un unique bloc 111. Une telle configuration est représentée sur les figures 8A et 8B, la figure 8B étant une vue en coupe selon l'axe AA représenté sur la figure 8A. Sur cet exemple, les portions d'espaceurs 135 de deux cellules mémoires adjacentes reposent sur deux flancs latéraux opposés du bloc 111 et sont respectivement en contact avec les portions d'espaceurs 136 reposant sur des flancs latéraux de deux grilles 114 des deux cellules mémoires adjacentes, et forment deux plots de contact électrique 130. Cet autre mode de réalisation permet d'augmenter la densité d'intégration des cellules mémoires au sein d'un dispositif mémoire.

Sur l'exemple des figures 8A et 8B, le bloc 111 est réalisé sur la zone d'isolation 106 afin d'éviter un couplage parasite entre le bloc 111 et le substrat 102. Toutefois, il est tout à fait possible de réaliser le bloc 111 sur une partie de zone active, comme représenté sur les figures 9A et 9B. Dans cette configuration, le bloc 111 sera réalisé tel que sa largeur soit supérieure à celle de la zone active sur laquelle le bloc est disposé. On évite ainsi que les portions 135 d'espaceurs disposées contre les flancs latéraux du bloc 111 se retrouvent couplées de manière parasite avec la zone active.

Un dispositif mémoire 3000 selon un autre mode de réalisation est représenté sur la figure 10. Par rapport aux dispositifs mémoires 1000 et 2000 précédemment décrits, les cellules mémoires 1002 de ce dispositif mémoire 3000 sont ici sensiblement similaires à la cellule mémoire 400 précédemment décrite en liaison avec la figure 4, c'est-à-dire comportant un plot de contact électrique 130 formé par des portions d'espaceurs disposées contre deux blocs formés l'un à côté de l'autre, à côté de la seconde grille 134. Une telle configuration permet donc de réaliser les contacts électriques 1014 sans risque de court-circuit entre la première et la seconde grille d'une cellule mémoire. Par rapport à la cellule mémoire 400 représentée sur la figure 4, les blocs 111 et 141 des cellules mémoires 1002 ne sont pas alignés tels que le premier bloc 111 soit disposé entre le deuxième bloc 141 et la première grille 114. En effet, dans les cellules mémoires 1002 représentées sur la figure 10, les deux blocs 111 et 141 sont alignés selon une direction perpendiculaire à la direction d'alignement des blocs 111 et 141 de la cellule mémoire 400, c'est-à-dire perpendiculairement à une direction source-drain. Cette configuration des cellules mémoires 1002 permet, par rapport à la cellule mémoire 400, de réduire la distance entre les lignes de mots 1006 et les lignes de mémorisation 1008, permettant ainsi d'augmenter la densité d'intégration des cellules mémoires 1002.

Là encore, lorsque l'on souhaite obtenir une forte densité des cellules mémoires 1002, il est possible de réaliser le dispositif mémoire 3000 tel que les contacts 1012, 1014 et 1016 soient décalés et proches les uns des autres afin de minimiser l'espace nécessaire à la réalisation de ces contacts électriques. De plus, il est également possible d'élargir les lignes de mots 1006 et/ou les lignes de mémorisation 1008 et/ou les lignes de sources 1010 afin de faciliter la reprise de contact électrique sur les cellules mémoires 1002.

Un dispositif mémoire 4000 selon un autre mode de réalisation est représenté sur la figure 11.

Par rapport au dispositif mémoire 3000 précédemment décrit, les cellules mémoires 1002 de ce dispositif mémoire 4000 comportent un plot de contact électrique 130 formé par des portions d'espaceurs disposés contre deux blocs 111 et 141 formés l'un à côté de l'autre, dans le prolongement de la première grille 114. Ainsi, par rapport au dispositif mémoire 3000, il est possible de rapprocher les lignes de mots 1006 et les lignes de mémorisation 1008, et augmenter ainsi la densité d'intégration des cellules mémoires 1002 au sein du dispositif mémoire 4000. Toutefois, afin de ne pas court-circuiter, au sein d'une colonne, la ligne de mot 1006 avec la ligne de mémorisation 1008, cette dernière est décalée latéralement par rapport à la ligne de mot 1006.

Là encore, il est possible d'élargir les lignes de mots 1006 et/ou les lignes de mémorisation 1008 et/ou les lignes de sources 1010 afin de faciliter la reprise de contact électrique sur les cellules mémoires 1002.

Dans un autre mode de réalisation, il est possible de réaliser les cellules mémoires 1002 du dispositif mémoire 3000 ou 4000 telles que les portions d'espaceur 145 servant à former les plots de contact électriques 130 de deux cellules mémoires adjacentes reposent sur les flancs latéraux d'un unique bloc 141.

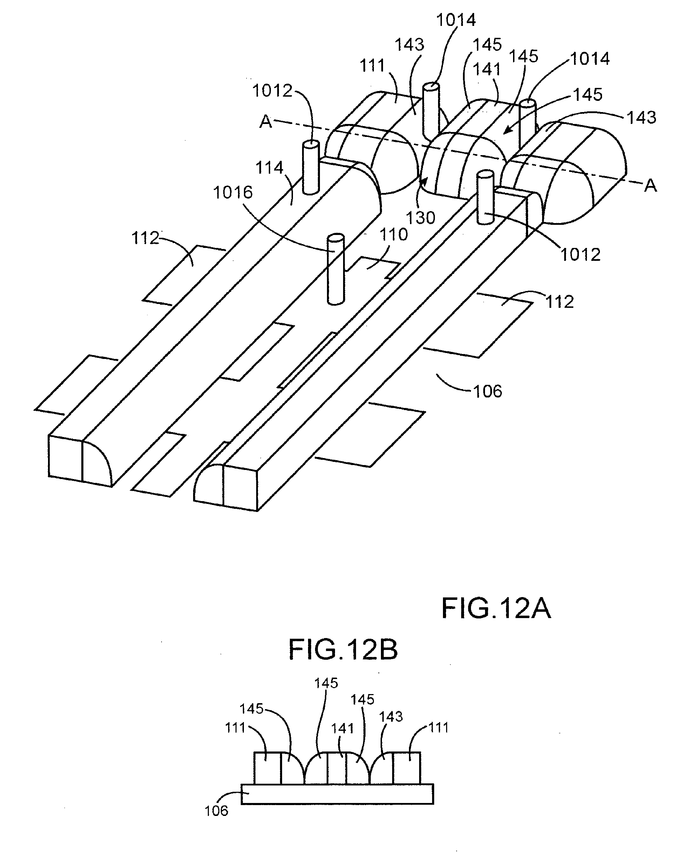

Une telle configuration est représentée sur les figures 12A et 12B, la figure 12B étant une vue en coupe selon l'axe AA représenté sur la figure 12A. Sur cet exemple, les portions d'espaceurs 145 reposent sur deux flancs latéraux opposés du bloc 141 et sont respectivement en contact avec les portions d'espaceurs 143 reposant sur des flancs latéraux de deux blocs 111 de deux cellules mémoires adjacentes, et forment deux plots de contact électrique 130. Cet autre mode de réalisation permet d'augmenter la densité d'intégration des cellules mémoires au sein d'un dispositif mémoire.

Sur cet exemple, le bloc 141 est réalisé sur la zone d'isolation 106 afin d'éviter un couplage parasite entre le bloc 141 et le substrat 102.

Toutefois, comme pour l'exemple précédemment décrit en liaison avec les figures 9A et 9B, le bloc 141 pourrait être disposé sur une partie de la zone active. Dans ce cas, le bloc 141 serait réalisé tel que sa largeur soit supérieure à celle de la zone active sur laquelle le bloc 141 est disposé, afin d'éviter que les portions 145.1 et 145.2 d'espaceurs disposées contre les flancs latéraux du bloc 141 se retrouvent couplées de manière parasite avec la zone active.

A titre indicatif, on donne ci-dessous des valeurs de tensions appliquées sur les différentes électrodes de telles cellules mémoires pour différentes opérations :

| | **Vs (V)** | **Vd (V)** | **Vg1 (V) (Transistor d'accès)** | **Vg2 (V) (Transistor mémoire)** |
|---|---|---|---|---|
| **Ecriture Source Side Injection** | 0,5 | 6 | 1 | 10 |
| **Effacement Band to Band Tunneling** | open | 6 | 0 | -6 |
| **Lecture** | 1,5 | 0 | 1,5 | 1,5 |

## Revendications

1. Cellule mémoire électronique (100, 200, 300, 400, 1002) comprenant au moins :
- une zone active formée dans une couche (102) de semi-conducteur et comportant un canal (108) disposé entre une source (110) et un drain (112),
- une première grille (114) disposée au moins sur une première partie du canal (108),
- au moins une portion d'un premier espaceur latéral (128) disposé contre au moins un flanc latéral de la première grille (114), dont une partie forme une seconde grille (134) disposée sur au moins une seconde partie du canal (108),
l'une de la première (114) ou de la seconde grille (134) comportant en outre un empilement de couches (117) dont au moins une (120) desdites couches est apte à stocker des charges électriques,
la cellule mémoire (100, 200, 300, 400, 1002) comportant en outre au moins une portion (135, 143) d'un deuxième espaceur latéral (133) disposé contre au moins un flanc latéral d'un bloc (111) distinct de la première grille (114) et disposé sur la couche de semi-conducteur (102), le deuxième espaceur latéral (133) étant en contact avec le premier espaceur latéral (128), le premier (128) et le second espaceur latéral (133) étant composés de matériaux similaires, ladite portion (135, 143) du second espacer latéral (133) formant au moins une partie d'un plot de contact électrique (130) relié électriquement à la seconde grille (134).

2. Cellule mémoire électronique (100, 200, 400, 1002) selon la revendication 1, dans laquelle la portion du premier espaceur latéral (128) est rectiligne.

3. Cellule mémoire électronique (300, 1002) selon la revendication 1, dans laquelle la portion du premier espaceur latéral (128) est disposée contre deux flancs latéraux de la première grille (114) distincts et perpendiculaires l'un par rapport à l'autre.

4. Cellule mémoire électronique (100, 200, 300, 400, 1002) selon l'une des revendications précédentes, dans laquelle le bloc (111) est formé par des matériaux similaires à ceux formant une partie de la première grille (114).

5. Cellule mémoire électronique (100, 200, 300, 400, 1002) selon l'une des revendications précédentes, dans laquelle la couche (120) apte à stocker des charges électrique dudit empilement de couches (117) est disposée entre deux couches (118, 122) de matériau diélectrique dudit empilement (117).

6. Cellule mémoire électronique (100, 300, 400, 1002) selon l'une des revendications précédentes, dans laquelle, lorsque la seconde grille (134) comporte ledit empilement de couches (117), le second espaceur latéral (133) est formé d'une partie des couches dudit empilement (117).

7. Cellule mémoire électronique (100, 200, 300, 1002) selon l'une des revendications précédentes, dans laquelle le plot de contact électrique (130) est en partie formé par la portion du premier espaceur (128).

8. Cellule mémoire électronique (400, 1002) selon l'une des revendications précédentes, comportant en outre au moins une portion (145) d'un troisième espaceur latéral (147) disposé contre au moins un flanc latéral d'un second bloc (141) et en contact avec le deuxième espaceur latéral (133), et dans laquelle le premier (128), le second (133) et le troisième espaceur latéral (147) sont composés de matériaux similaires, le plot de contact électrique (130) étant en partie formé par la portion (145) du troisième espaceur latéral (147).

9. Cellule mémoire électronique (1002) selon la revendication 8, dans laquelle le premier (111) et le second bloc (141) sont alignés l'un par rapport à l'autre selon une direction perpendiculaire à une direction source-drain.

10. Cellule mémoire électronique (400) selon l'une des revendications 8 ou 9, comportant en outre au moins une portion (149, 151) de plusieurs autres espaceurs latéraux (153, 155) disposés contre au moins un flanc latéral de plusieurs autres blocs (157, 159) et en contact avec le deuxième espaceur latéral (133) et/ou le troisième espaceur latéral (147) et/ou un desdits autres espaceurs latéraux (153, 155), et dans laquelle les différents espaceurs latéraux (128, 133, 147, 153, 155) sont composés de matériaux similaires, le plot de contact électrique (130) étant formé également par au moins une partie des portions (149, 151) desdits autres espaceurs latéraux (153, 155).

11. Cellule mémoire électronique (100, 200, 300, 400, 1002) selon l'une des revendications précédentes, dans lequel le premier espaceur latéral (128) est disposé contre l'ensemble des flancs latéraux de la première grille (114), et/ou le second espaceur latéral (133) est disposé contre l'ensemble des flancs latéraux du bloc (111), et/ou, lorsque le plot de contact électrique (130) est en partie formé par la portion (145) du troisième espaceur latéral (147), le troisième espaceur latéral (147) est disposé contre l'ensemble des flancs latéraux du second bloc (141), et/ou, lorsque le plot de contact électrique (130) est formé par au moins une partie des portions (149, 151) desdits autres espaceurs latéraux (153, 155), lesdits autres espaceurs latéraux (153, 155) sont disposés contre l'ensemble des flancs latéraux desdits autres blocs (157, 159).

12. Procédé de réalisation d'une cellule mémoire électronique (100, 200, 300, 400, 1002) comprenant au moins les étapes de :
- réalisation, dans une couche de semi-conducteur (102), d'une zone active comportant un canal (108) disposé entre une source (110) et un drain (112),
- réalisation d'une première grille (114) disposée au moins sur une première partie du canal (108) et d'au moins un bloc (111) distinct de la première grille (114) et disposé sur la couche de semi-conducteur (102),
- dépôt d'une pluralité de couches de matériaux destinées à former au moins une seconde grille (134) sur au moins une seconde partie du canal (108), lesdites couches de matériaux recouvrant au moins la couche de semi-conducteur (102), la zone active, la première grille (114) et le bloc (111),
- gravure anisotrope desdites couches de matériaux telle qu'une première portion restante desdites couches de matériaux forme un premier espaceur latéral (128) disposé contre des flancs latéraux de la première grille (114), une partie du premier espaceur latéral (128) formant la seconde grille (134), et telle qu'une deuxième portion restante desdites couches de matériaux forme un deuxième espaceur latéral (133) disposé contre des flancs latéraux du bloc (111) et en contact avec le premier espaceur latéral (128), une portion (135, 143) du second espaceur latéral (133) formant au moins une partie d'un plot de contact électrique (130) relié électriquement à la seconde grille (134),
l'une de la première (114) ou de la seconde grille (134) comportant un empilement de couches (117) dont au moins une (120) desdites couches est apte à stocker des charges électriques.

13. Procédé selon la revendication 12, dans lequel la pluralité de couches de matériaux destinées à former la seconde grille (134) comprend au moins une couche électriquement conductrice disposée sur au moins une couche diélectrique.

14. Procédé selon l'une des revendications 12 ou 13, dans laquelle le bloc (111) et la première grille (114) sont réalisés à partir des mêmes couches de matériaux.

15. Procédé selon l'une des revendications 12 à 14, dans lequel, lors de la réalisation de la première grille (114), un second bloc (141) est également réalisé sur la couche de semi-conducteur (102), et dans lequel l'étape de gravure anisotrope forme également un troisième espaceur latéral (147) disposé contre des flancs latéraux du second bloc (141), au moins une portion (145) du troisième espaceur (147) latéral étant en contact avec le deuxième espaceur latéral (133) et formant au moins une partie du plot de contact électrique (130).

16. Procédé selon la revendication 15, dans lequel, lors de la réalisation de la première grille (114), plusieurs autres blocs (157, 159) sont également réalisés sur la couche de semi-conducteur (102), et dans lequel l'étape de gravure anisotrope forme également plusieurs autres espaceurs latéraux (153, 155) disposés contre des flancs latéraux desdits autres blocs (157, 159), au moins une portion (149, 151) desdits autres espaceurs latéraux (153, 155) étant en contact avec le deuxième espaceur latéral (133) et/ou le troisième espaceur latéral (147) et/ou un desdits autres espaceurs latéraux (153, 155), le plot de contact électrique (130) étant formé également par au moins une partie des portions (149, 151) desdits autres espaceurs latéraux (153, 155).

17. Procédé selon l'une des revendications 12 à 16, comportant en outre, après la gravure anisotrope desdites couches de matériaux, la mise en oeuvre d'une photolithographie et d'une gravure du premier (128) et/ou du deuxième (133) et/ou du troisième espaceur latéral (147) et/ou desdits autres espaceurs latéraux (153, 155), telles que des portions restantes du premier (128) et/ou du deuxième (133) et/ou du troisième espaceur latéral (147) et/ou desdits autres espaceurs latéraux (153, 155) forment la seconde grille (134) et le plot de contact électrique (130).

18. Procédé selon l'une des revendications 12 à 17, dans laquelle, lorsque la seconde grille (134) comporte ledit empilement de couches (117), le second espaceur latéral (133) est formé d'une partie des couches dudit empilement..

19. Dispositif mémoire (1000, 2000, 3000, 4000) comportant une pluralité de cellules mémoires (1002) selon l'une des revendications 1 à 11 disposées en matrice et reliées électriquement entre elles selon une architecture de type NOR.

20. Dispositif mémoire (1000, 2000, 3000, 4000) selon la revendication 19, dans lequel les deuxièmes espaceurs latéraux (133) de deux cellules mémoires (1002) adjacentes sont disposés contre deux flancs latéraux opposés d'un bloc (111) commun aux deux cellules mémoires (1002) adjacentes.

21. Dispositif mémoire (3000, 4000) selon la revendication 19, dans lequel, lorsque les plots de contact électriques (130) de deux cellules mémoires (1002) adjacentes sont formés par des deuxièmes (133) et des troisièmes espaceurs latéraux (147), lesdits troisièmes espaceurs latéraux (147) sont disposés contre deux flancs latéraux opposés d'un second bloc (141) commun aux deux cellules mémoires (1002) adjacentes.

22. Procédé de réalisation d'un dispositif mémoire (1000, 2000, 3000, 4000) comportant au moins les étapes de :
- réalisation d'une pluralité de cellules mémoires (1002) disposées en matrice, comportant, pour la réalisation d'au moins une cellule mémoire (1002) de chaque colonne de la matrice, la mise en oeuvre d'un procédé de réalisation selon l'une des revendications 12 à 18,
- réalisation d'interconnexions électriques (1004, 1006, 1008, 1010, 1012, 1014, 1016) de la pluralité de cellules mémoire (1002) telles que les cellules mémoires (1002) soient reliées électriquement entre elles selon une architecture de type NOR.

## Patentansprüche

1. Elektronische Speicherzelle (100, 200, 300, 400, 1002), wenigstens umfassend :
- eine aktive Zone, ausgebildet in einer Halbleiterschicht (102), einen Kanal (108) zwischen einer Source (110) und einem Drain (112) umfassend ,
- ein erstes Gate (114), angeordnet auf wenigstens einem ersten Teil des Kanals (108),
- wenigstens ein Teilstück eines ersten seitlichen Spacers (128), angeschmiegt an wenigstens eine seitliche Flanke des ersten Gates (114), von dem ein Teil ein zweites Gate (134) bildet, angeordnet auf wenigstens einem zweiten Teil des Kanals (108),
wobei entweder das erste (114) oder das zweite Gate (134) außerdem einen Schichtenstapel (117) umfasst und wenigstens eine (120) der genannten Schichten fähig ist, elektrische Ladungen zu speichern,
wobei die Speicherzelle (100, 200, 300, 400, 1002) außerdem ein Teilstück (135, 143) eines zweiten seitlichen Spacers (133) umfasst, angeschmiegt an wenigstens eine seitliche Flanke eines Blocks (111) separat vom ersten Gate (114) und angeordnet auf der Halbleiterschicht (102), der zweite seitliche Spacer (133) Kontakt hat mit dem ersten seitlichen Spacer (128), der erste (128) und der zweite seitliche Spacer (133) aus ähnlichen bzw. gleichen Materialien bestehen, das genannte Teilstück (135, 143) des zweiten seitlichen Spacers (133) wenigstens einen Teil einer elektrischen Kontaktstelle (130) bildet, elektrisch verbunden mit dem zweiten Gate (134).

2. Elektronische Speicherzelle (100, 200, 400, 1002) nach Anspruch 1, bei der das Teilstück des ersten seitlichen Spacers (128) geradlinig ist.

3. Elektronische Speicherzelle (300, 1002) nach Anspruch 1, bei der das Teilstück des ersten seitlichen Spacers (128) an zwei verschiedenen und zueinander senkrechten seitlichen Flanken des ersten Gates (114) angeschmiegt ist.

4. Elektronische Speicherzelle (100, 200, 300, 400, 1002) nach einem der vorhergehenden Ansprüche, bei der der Block (111) durch Materialien gebildet wird, die denen entsprechen, die einen Teil des ersten Gates (114) bilden.

5. Elektronische Speicherzelle (100, 200, 300, 400, 1002) nach einem der vorhergehenden Ansprüche, bei der die zum Speichern von elektrischen Ladungen fähige Schicht (120) des genannten Schichtenstapels (117) zwischen zwei Schichten (118, 122) des dielektrischen Materials des genannten Stapels (117) angeordnet ist.

6. Elektronische Speicherzelle (100, 300, 400, 1002) nach einem der vorhergehenden Ansprüche, bei der, wenn das zweite Gate (134) den genannten Schichtenstapel (117) umfasst, der zweite seitliche Spacer (133) durch einen Teil der Schichten des genannten Stapels (117) gebildet wird.

7. Elektronische Speicherzelle (100, 200, 300, 1002) nach einem der vorhergehenden Ansprüche, bei der die elektrische Kontaktstelle (130) teilweise durch das Teilstück des ersten Spacers (128) gebildet wird.

8. Elektronische Speicherzelle (400, 1002) nach einem der vorhergehenden Ansprüche, die außerdem wenigstens ein Teilstück (145) eines dritten seitlichen Spacers (147) umfasst, angeschmiegt an wenigstens eine seitliche Flanke eines zweiten Blocks (141) und in Kontakt mit dem zweiten seitlichen Spacer (133), und bei der der erste (128), der zweite (133) und der dritte seitliche Spacer (147) durch gleiche bzw. ähnliche Materialien gebildet werden, wobei die elektrische Kontaktstelle (130) teilweise durch das Teilstück (145) des dritten seitlichen Spacers (147) gebildet wird.

9. Elektronische Speicherzelle (1002) nach Anspruch 8, bei der der erste (111) und der zweite Block (141) miteinander in einer zu einer Source-Drain-Richtung senkrechten Richtung fluchten.

10. Elektronische Speicherzelle (400) nach einem der Ansprüche 8 oder 9, die außerdem wenigstens ein Teilstück (149, 151) von mehreren anderen seitlichen Spacern (153, 155), angeschmiegt an wenigstens eine seitliche Flanke von mehreren anderen Blöcken (157, 159) umfasst und Kontakt hat mit dem zweiten seitlichen Spacer (133) und/oder dem dritten seitlichen Spacer (147) und/oder einem der anderen seitlichen Spacer (153, 155), und bei der die verschiedenen seitliche Spacer (128, 133, 147, 153, 155) aus ähnlichen bzw. gleichen Materialien sind, wobei die elektrische Kontaktstelle (130) ebenfalls durch wenigstens einen Teil der Teilstücke (149, 151) der genannten anderen seitlichen Spacer (153, 155) gebildet wird.

11. Elektronische Speicherzelle (100, 200, 300, 400, 1002) nach einem der vorhergehenden Ansprüche, bei der der erste seitliche Spacer (128) an alle seitlichen Flanken des ersten Gates (114) angeschmiegt ist, und/oder der zweite seitliche Spacer (133) an alle seitlichen Flanken des Blocks (111) angeschmiegt ist, und/oder, wenn die elektrische Kontaktstelle (130) teilweise durch das Teilstück (145) des dritten seitlichen Spacers (147) gebildet wird, der dritte seitliche Spacer (147) an alle seitlichen Spacer des zweiten Blocks (141) angeschmiegt ist, und/oder, wenn die Kontaktstelle (130) durch wenigstens einen Teil der Teilstücke (149, 151) der genannten anderen seitlichen Spacer (153, 155) gebildet wird, die genannten anderen seitlichen Spacer (153, 155) an alle seitlichen Flanken der genannten anderen Blöcke (157, 159) angeschmiegt sind.

12. Verfahren zur Herstellung einer Elektronische Speicherzelle (100, 200, 300, 400, 1002), wenigstens folgende Schritte umfassend :
- Realisierung - in einer Halbleiterschicht - einer einen Kanal (108) umfassenden aktiven Zone, der zwischen einer Source ((110) und einem Drain (112) angeordnet ist,
- Realisierung eines ersten Gates (114), angeordnet auf wenigstens einem ersten Teil des Kanals (108), und wenigstens einen Block (111) separat vom ersten Gate (114) und angeordnet auf der Halbleiterschicht (102),
- Abscheidung einer Vielzahl von Materialschichten, bestimmt zur Bildung eines zweiten Gates (134) auf wenigstens einem zweiten Teil des Kanals (108), wobei die genannten Materialschichten wenigstens die Halbleiterschicht (102), die aktive Zone, das erste Gate (114) und den Block (111) bedecken,
- anisotrope Ätzung der genannten Materialschichten derart, dass ein erstes restliches Teilstück der genannten Materialschichten einen ersten, an seitliche Flanken des ersten Gates (114) angeschmiegten seitlichen Spacer (128) bildet, wobei ein Teil des ersten seitlichen Spacers (128) das zweite Gate (134) bildet, und derart, dass ein zweites restliches Teilstück der genannten Materialschichten einen zweiten, an seitliche Flanken des Blocks (111) angeschmiegten seitlichen Spacer (133) mit Kontakt zu dem ersten seitlichen Spacer (128) bildet, wobei ein Teilstück (135, 143) des zweiten seitlichen Spacers (133) wenigstens einen Teil einer elektrisch mit dem zweiten Gate (134) verbundenen elektrischen Kontaktstelle (130) bildet,
wobei entweder das erste (114) oder das zweite Gate (134) einen Schichtenstapel (117) mit wenigstens einer zur Speicherung von elektrischen Ladungen befähigten Schicht (120) umfasst.

13. Verfahren nach Anspruch 12, bei dem die Vielzahl der zur Bildung des zweiten Gates (134) bestimmten Schichten wenigstens eine elektrisch leitfähige Schicht umfasst, angeordnet auf wenigstens einer dielektrischen Schicht.

14. Verfahren nach einem der Ansprüche 12 oder 13, bei dem der Block (111) und das erste Gate (114) aus denselben Materialschichten realisiert werden.

15. Verfahren nach einem der Ansprüche 12 bis 14, bei dem während der Realisierung des ersten Gates (114) auf der Halbleiterschicht (102) ebenfalls ein zweiter Block (141) realisiert wird, und bei dem der anisotrope Ätzschritt ebenfalls einen dritten seitlichen Spacer (147) bildet, angeschmiegt an seitliche Flanken des zweiten Blocks (141), wobei wenigstens ein Teilstück (145) des dritten seitlichen Spacers (147) Kontakt hat mit dem zweiten seitlichen Spacer (133) und wenigstens einen Teil der elektrischen Kontaktstelle (130) bildet.

16. Verfahren nach Anspruch 15, bei dem während der Realisierung des ersten Gates (114) auf der Halbleiterschicht (102) ebenfalls mehrere andere Blöcke (157, 159) realisiert werden, und bei dem der anisotrope Ätzschritt ebenfalls mehrere andere seitlichen Spacer (153, 155) bildet, angeschmiegt an seitliche Flanken der genannten anderen Blöcke (157, 159), wobei wenigstens ein Teilstück (149, 151) der genannten anderen Spacer (153, 155) Kontakt hat mit dem zweiten seitlichen Spacer (133) und/oder dem dritten seitlichen Spacer (147) und/oder einem der genannten anderen seitlichen Spacer (153, 155), wobei die elektrische Kontaktstelle (130) ebenfalls durch wenigstens einen Teil der Teilstücke (149, 151) der genannten anderen seitlichen Spacer (153, 155) gebildet wird.

17. Verfahren nach einem der Ansprüche 12 bis 16, das außerdem, nach der anisotropen Ätzung der genannten Materialschichten, die Durchführung einer Photolithographie und einer Ätzung des ersten (128) und/oder zweiten (133) und/oder dritten seitlichen Spacers (147) und/oder der genannten anderen seitlichen Spacer (153, 155) umfasst, derart dass die restlichen Teilstücke des ersten (128) und/oder zweiten (133) und/oder dritten seitlichen Spacers (147) und/oder der genannten anderen seitlichen Spacer (153, 155) das zweite Gate (134) und die elektrische Kontaktstelle (130) bilden.

18. Verfahren nach einem der Ansprüche 12 bis 17, bei dem, wenn das zweite Gate (134) den genannten Schichtenstapel (117) umfasst, der zweite seitliche Spacer (133) durch einen Teil der Schichten des genannten Stapels gebildet wird.

19. Speichervorrichtung (1000, 2000, 3000, 4000) mit einer Vielzahl von Speicherzellen (1002) nach einem der Ansprüche 1 bis 11, matrixförmig angeordnet und mit- bzw. untereinander verbunden gemäß einer Architektur des NOR-Typs.

20. Speichervorrichtung (1000, 2000, 3000, 4000) nach Anspruch 19, bei der die zweiten seitlichen Spacer (133) zweier benachbarter Speicherzellen (1002) angeschmiegt sind an zwei entgegengesetzte seitliche Flanken eines für die beiden benachbarten Speicherzellen (1002) gemeinsamen Blocks (111).

21. Speichervorrichtung (3000, 4000) nach Anspruch 19, bei der, wenn die elektrischen Kontaktstellen (130) der beiden benachbarten Speicherzellen (1002) durch zweite (133) und dritte seitliche Spacer (147) gebildet werden, die genannten dritten seitlichen Speicher (147) angeschmiegt sind an zwei entgegengesetzte seitliche Flanken eines für die beiden benachbarten Speicherzellen (1002) gemeinsamen Blocks (141).

22. Verfahren zur Herstellung einer Speichervorrichtung (1000, 2000, 3000, 4000), wenigstens folgende Schritte umfassend :
- Realisierung einer Vielzahl von matrixförmig angeordneten Speicherzellen (1002), umfassend - zur Realisierung wenigstens einer Speicherzelle (1002) von jeder Spalte der Matrix
- die Durchführung eines Realisierungsverfahrens nach einem der Ansprüche 12 bis 18,
- Realisierung einer elektrischen Zusammenschaltung (1004, 1006, 1008, 1010, 1012, 1014, 1016) der Vielzahl von Speicherzellen (1002), derart dass die Speicherzellen (1002) gemäß einer Architektur des NOR-Typs elektrisch mit- bzw. untereinander verbunden sind.

## Claims

1. Electronic memory cell (100, 200, 300, 400, 1002) including at least:
- one active area formed in a semi-conductor layer (102) and including a channel (108) provided between a source (110) and a drain (112),
- one first gate (114) provided at least on one first part of the channel (108),
- at least one portion of a first lateral spacer (128) provided against at least one lateral flank of the first gate (114), a part of which forms a second gate (134) provided on at least one second part of the channel (108),
one of the first (114) or the second gate (134) further including a stack of layers (117), of which at least one (120) of said layers is capable of storing electrical charges,
the memory cell (100, 200, 300, 400, 1002) further including at least one portion (135, 143) of a second lateral spacer (133) provided against at least one lateral flank of a block (111) distinct from the first gate (114) and provided on the semi-conductor layer (102), the second lateral spacer (133) being in contact with the first lateral spacer (128), the first (128) and second lateral spacers (133) being composed of similar materials, said portion (135, 143) of the second lateral spacer (133) forming at least one part of an electrical contact pad (130) electrically connected to the second gate (134).

2. Electronic memory cell (100, 200, 400, 1002) according to claim 1, wherein the portion of the first lateral spacer (128) is rectilinear.

3. Electronic memory cell (300, 1002) according to claim 1, wherein the portion of the first lateral spacer (128) is provided against two lateral flanks of the first gate (114) which are distinct and perpendicular to each other.

4. Electronic memory cell (100, 200, 300, 400, 1002) according to one of previous claims, wherein the block (111) is formed by materials similar to those forming a part of the first gate (114).

5. Electronic memory cell (100, 200, 300, 400, 1002) according to one of previous claims, wherein the layer (120) capable of storing electrical charges of said stack of layers (117) is provided between two dielectric material layers (118, 122) of said stack (117).

6. Electronic memory cell (100, 300, 400, 1002) according to one of previous claims, wherein, when the second gate (134) includes said stack of layers (117), the second lateral spacer (133) is formed by a part of the layers of said stack (117).

7. Electronic memory cell (100, 200, 300, 1002) according to one of previous claims, wherein the electrical contact pad (130) is partly formed by the portion of the first spacer (128).

8. Electronic memory cell (400, 1002) according to one of previous claims, further including at least one portion (145) of a third lateral spacer (147) provided against at least one lateral flank of a second block (141) and in contact with the second lateral spacer (133), and wherein the first (128), second (133) and third lateral spacers (147) are composed of similar materials, the electrical contact pad (130) being partly formed by the portion (145) of the third lateral spacer (147).

9. Electronic memory cell (1002) according to claim 8, wherein the first (111) and second blocks (141) are aligned with respect to each other along a direction perpendicular to a source-drain direction.

10. Electronic memory cell (400) according to one of claims 8 or 9, further including at least one portion (149, 151) of several other lateral spacers (153, 155) provided against at least one lateral flank of several other blocks (157, 159) and in contact with the second lateral spacer (133) and/or the third lateral spacer (147) and/or one of said other lateral spacers (153, 155), and wherein the different lateral spacers (128, 133, 147, 153, 155) are composed of similar materials, the electrical contact pad (130) being also formed by at least one part of the portions (149, 151) of said other lateral spacers (153, 155).

11. Electronic memory cell (100, 200, 300, 400, 1002) according to one of previous claims, wherein the first lateral spacer (128) is provided against all the lateral flanks of the first gate (144) and/or the second lateral spacer (133) is provided against all the lateral flanks of the block (111) and/or, when the electrical contact pad (130) is partly formed by the portion (145) of the third lateral spacer (147), the third lateral spacer (147) is provided against all the lateral flanks of the second block (141) and/or, when the electrical contact pad (130) is formed by at least one part of the portions (149, 151) of said other lateral spacers (153, 155), said other lateral spacers (153, 155) are provided against all the lateral flanks of said other blocks (157, 159).

12. Method for making an electronic memory cell (100, 200, 300, 400, 1002) including at least the steps of:
- making, in a semi-conductor layer (102), an active area including a channel (108) provided between a source (110) and a drain (112),
- making a first gate (114) provided at least on one first part of the channel (108), and at least one block (111) distinct from the first gate (114) and provided on the semi-conductor layer (102),
- depositing a plurality of material layers for forming at least one second gate (134) on at least one second part of the channel (108), said material layers covering at least the semi-conductor layer (102), the active area, the first gate (114) and the block (111),
- anisotropically etching said material layers such that a first remaining portion of said material layers forms a first lateral spacer (128) provided against lateral flanks of the first gate (114), a part of the first lateral spacer (128) forming the second gate (134), and such that a second remaining portion of said material layers forms a second lateral spacer (133) provided against lateral flanks of the block (111) and in contact with the first lateral spacer (128), a portion (135, 143) of the second lateral spacer (133) forming at least one part of an electrical contact pad (130) electrically connected to the second gate (134),
one the first (114) or the second gate (134) including a stack of layers (117), of which at least one (120) of said layers is capable of storing electrical charges.

13. Method according to claim 12, wherein the plurality of material layers for forming the second gate (134) comprises at least one electrically conducting layer provided on at least one dielectric layer.

14. Method according to one of claims 12 or 13, wherein the block (111) and the first gate (114) are made from the same material layers.

15. Method according to one of claims 12 to 14, wherein, upon making the first gate (114), a second block (141) is also made on the semi-conductor layer (102), and wherein the step of anisotropically etching also forms a third lateral spacer (147) provided against lateral flanks of the second block (141), at least one portion (145) of the third lateral spacer (147) being in contact with the second lateral spacer (133) and forming at least one part of the electrical contact pad (130).

16. Method according to claim 15, wherein, upon making the first gate (114), several other blocks (157, 159) are also made on the semi-conductor layer (102), and wherein the step of anisotropically etching also forms several other lateral spacers (153, 155) provided against lateral flanks of said other blocks (157, 159), at least one portion (149, 151) of said other lateral spacers (153, 155) being in contact with the second lateral spacer (133) and/or the third lateral spacer (147) and/or one of said other lateral spacers (153, 155), the electrical contact pad (130) being also formed by at least one part of the portions (149, 151) of said other lateral spacers (153, 155).

17. Method according to one of claims 12 to 16, further including, after the anisotropically etching of said material layers, implementing a photolithography and etching of the first (128) and/or second (133) and/or third lateral spacer (147) and/or of said other lateral spacers (153, 155), such that remaining portions of the first (128) and/or second (133) and/or third lateral spacer (147) and/or of said other lateral spacers (153, 155) form the second gate (134) and the electrical contact pad (130).

18. Method according to one of claims 12 to 17, wherein, when the second gate (134) includes said stack of layers (117), the second lateral spacer (133) is formed by a part of the layers of said stack.

19. Memory device (1000, 2000, 3000, 4000) including a plurality of memory cells (1002) according to one of claims 1 to 11, provided in an array and electrically connected with each other according to a NOR type architecture.

20. Memory device (1000, 2000, 3000, 4000) according to claim 19, wherein the second lateral spacers (133) of two adjacent memory cells (1002) are provided against two opposite lateral flanks of a block (111) common to both adjacent memory cells (1002).

21. Memory device (3000, 4000) according to claim 19, wherein, when the electrical contact pads (130) of two adjacent memory cells (1002) are formed by second (133) and third lateral spacers (147), said third lateral spacers (147) are provided against two opposite lateral flanks of a second block (141) common to both adjacent memory cells (1002).

22. Method for making a memory device (1000, 2000, 3000, 4000) including at least the steps of:
- making a plurality of memory cells (1002) provided in an array, including, for making at least one memory cell (1002) of each column of the array, implementing a making method according to one of claims 12 to 18,
- making electrical interconnections (1004, 1006, 1008, 1010, 1012, 1014, 1016) of the plurality of memory cells (1002) such that the memory cells (1002) are electrically connected between each other according to a NOR type architecture.
